# EUROPÄISCHE PATENTANMELDUNG

(11) **EP 2 607 007 A1**
(43) Veröffentlichungstag der Anmeldung: **26.06.2013**
(21) Anmeldenummer: 11405371.3
(22) Anmeldetag: 19.12.2011
(51) Int. Cl.: B23K 3/047, B23K 1/002, B23K 1/00, B23K 3/08, H01L 31/18, H05K 3/34

(54) **Lötvorrichtung zum Befestigen eines elektrisch leitfähigen Bandes an einer Solarzelle**

(71) Anmelder: Komax Holding AG, 6036 Dierikon (CH)
(72) Erfinder: Meisser, Claudio, 6330 Cham (CH); Dingle, Brad M., Red Lion, PA 17356 (US); Hofer, Adolf, 8426 Lufingen (CH)
(74) Vertreter: EGLI-EUROPEAN PATENT ATTORNEYS

(57) **Zusammenfassung**

Die vorliegende Erfindung betrifft eine Lötvorrichtung (8) zum Befestigen eines elektrisch leitfähigen Bandes (5) an einer geraden Stromsammelschiene (3) einer Solarzelle (1), entlang einer geraden Lötlinie (L), mittels induktiven Löten. Insbesondere ist ein Strompfad (SP) der erfindungsgemässen Lötvorrichtung (8) in einem elektrisch leitfähigen Festkörper (20) ausgebildet, wobei dieser Festkörper (20) mindestens einen sich im Wesentlichen parallel zur Lötlinie (L) erstreckenden Teil (FSP) umfasst, welcher durch einen Luftspalt (LS) von der Lötlinie (L) getrennt ist und in welchem mindestens ein Abschnitt des Strompfads (SPA) ausgebildet ist. Der sich im Wesentlichen parallel zur Lötlinie (L) erstreckende Teil (FSP) weist mehrere Ausnehmungen (21) auf, welche in einer Reihe hintereinander entlang der Lötlinie (L) angeordnet sind. Die Ausnehmungen (21) erstrecken sich entlang einer Lötebene (LE) jeweils vertikal zur Lötlinie (L) derart, dass jeweils ein Niederhalterelement (P) bewegbar in einer der Ausnehmungen (21) angeordnet ist. Der sich im Wesentlichen parallel zur Lötlinie (L) erstreckende Teil (FSP) umfasst mehrere längliche Abschnitte (LA), von denen jeder eine sich parallel zur Lötlinie (L) erstreckende Längsachse aufweist. Zwischen jeweils zwei der Ausnehmungen (21), welche in der einen Reihe unmittelbar hintereinander angeordnet sind, ist jeweils einer der länglichen Abschnitte (LA) angeordnet. Der jeweils eine, zwischen den zwei Ausnehmungen (21) angeordnete längliche Abschnitt (LA) erstreckt sich geradlinig und parallel zur Lötlinie (L) von einer dieser zwei Ausnehmungen (21) zur anderen dieser zwei Ausnehmungen (21).

## Beschreibung

Die Erfindung bezieht sich auf eine Lötvorrichtung zum Befestigen eines elektrisch leitfähigen Bandes an einer Solarzelle. Insbesondere handelt es sich bei der erfindungsgemässen Lötvorrichtung um eine Lötvorrichtung, welche Lötverbindungen durch induktives Löten, d.h. durch induktives Erhitzen der miteinander zu verbindenden Teile, herstellt.

Demgemäss betrifft die Erfindung eine Lötvorrichtung zum Befestigen eines elektrisch leitfähigen Bandes an einer geraden Stromsammelschiene einer Solarzelle entlang einer geraden Lötlinie mittels induktiven Lötens. Die erfindungsgemässe Lötvorrichtung weist mehrere Niederhalteelemente zum Niederhalten des Bandes auf einer Oberfläche der Stromsammelschiene auf. Die Niederhalteelemente sind derart ausgebildet, dass sie sich jeweils senkrecht zur Lötlinie und entlang einer Lötebene, in welcher die Lötlinie liegt, erstrecken. Ferner sind die Niederhalteelemente in einer Reihe hintereinander derart angeordnet, dass zwischen jeweils zwei der Niederhalteelemente, welche in der Reihe unmittelbar hintereinander angeordnet sind, ein Zwischenraum ausgebildet ist und dass sie in der Lötebene relativ zu der Lötlinie bewegbar sind. Die erfindungsgemässe Lötvorrichtung umfasst weiterhin eine Induktionsantenne mit einem sich entlang der Lötlinie erstreckenden Strompfad für einen elektrischen Wechselstrom. Der elektrische Wechselstrom ist derart entlang des Strompfades geführt, dass er in der Lötlinie oder in einer Umgebung der Lötlinie ein magnetisches Wechselfeld erzeugt.

Die oben erwähnten Lötvorrichtungen sind dem Prinzip nach bereits aus dem Stand der Technik bekannt. Die bekannten Lötvorrichtungen dienen zum Verbinden mehrerer Solarzellen zu einem Band ("string"), wobei mehrere Bänder zusammen ein Modul oder auch Panel ergeben. Um die einzelnen Solarzellen zu einem Band zusammenzuschalten, ist es nötig, Stromsammelschienen auf der Oberseite einer ersten Solarzelle mit Stromsammelschienen auf der Unterseite einer zweiten Solarzelle zu verbinden. Somit entsteht eine Reihenschaltung mehrerer Solarzellen zu einem Band, wodurch die gesamte elektrische Energie der einzelnen Solarzellen gesammelt abgegriffen werden kann. Um die geraden Stromsammelschienen auf der Oberseite der ersten Solarzelle mit den geraden Stromsammelschienen auf der Unterseite der zweiten Solarzelle zu verbinden, werden elektrisch leitfähige Bänder mit den jeweiligen Stromsammelschienen verlötet, sodass jeweils ein elektrisch leitfähiges Band die jeweiligen Stromsammelschienen miteinander verbindet. Eine jede Solarzelle kann eine Vielzahl an geraden Stromsammelschienen aufweisen, welche mit einem elektrisch leitfähigen Band verlötet werden müssen. Dazu werden die elektrisch leitfähigen Bänder über den geraden Stromsammelschienen angeordnet und vorzugsweise mittels induktivem Löten mit diesen verbunden. Dementsprechend erfolgt der Lötprozess entlang einer Lötlinie, welche wiederum entlang der geraden Stromsammelschiene verläuft. Mit anderen Worten handelt es sich bei der Lötlinie, um eine mathematische Gerade, welche sich entlang der geraden Stromsammelschiene erstreckt.

Um das elektrisch leitfähige Band während des Lötprozesses an der geraden Stromsammelschiene zu befestigen, ist es aus dem Stand der Technik bekannt, mehrere Niederhalterelemente typischerweise in einem Abstand von 8 bis 25 mm vorzusehen. Diese Niederhalterelemente sind vorzugsweise aus einem Keramikwerkstoff gebildete zylindrische Stifte mit einem Durchmesser von ca. 3 mm, welche nicht elektrisch leitfähig und insbesondere auch nicht magnetisierbar sind. Im Einzelnen dienen die Niederhalterelemente dazu, das elektrisch leitfähige Band mit einer senkrechten Kraft zu beaufschlagen, um dieses entlang der Lötlinie der geraden Stromsammelschiene zu fixieren.

Bei den aus dem Stand der Technik bekannten Lötvorrichtungen ist es ferner bekannt, dass die Niederhalterelemente senkrecht zur Lötlinie und entlang einer Lötebene beweglich durch eine Induktionsantenne geführt werden. Die Lötebene ist insbesondere senkrecht zu einer Ebene, in welcher die Solarzelle liegt, ausgerichtet und verläuft entlang der Lötlinie. Dementsprechend ist die Lötebene parallel zur Lötlinie ausgerichtet und die Lötlinie liegt in der Lötebene.

In diesem Zusammenhang sei beispielsweise auf die europäische Patentanmeldung EP 2 103 373 A1 hingewiesen. Aus dieser Druckschrift ist es bekannt, eine Induktionsantenne vorzusehen, in der ein hochfrequenter elektrischer Wechselstrom ein hochfrequentes magnetisches Wechselfeld erzeugt, welches in der Stromsammelschiene und dem entlang der Stromsammelschiene angeordneten elektrisch leitfähigen Band Wirbelströme induziert, welche die für den Lötvorgang notwendige Wärme erzeugen. Die bekannte Induktionsantenne ist im Wesentlichen U-förmig ausgebildet und weist Verengungen und Aufweitungen auf, wobei die Aufweitungen einen Zugang zur Lötstelle für die magnetfeldneutralen Niederhalterelemente darstellen. Somit ist es aus dem Stand der Technik bekannt, die Induktionsantenne zum Erzeugen eines magnetischen Wechselfeldes mit wellenförmigen Schenkeln auszubilden, welche zur Führung der Niederhalterelemente dienen. Insbesondere werden die wellenförmigen Schenkel durch Verbiegen um die Niederhalterelemente herumgeführt. Dabei sind typischerweise Biegeradien von grösser oder gleich 5 mm erzielbar.

Bei den aus dem Stand der Technik bekannten Lötvorrichtungen wird es als problematisch angesehen, dass die wellenförmig ausgebildeten Induktionsantennen lediglich ein sehr inhomogenes Magnetfeld erzeugen. Dies ist gerade aufgrund der relativ grossen Biegeradien ausschlaggebend. Im Einzelnen wird an den Verengungen der bekannten wellenförmigen Schenkel ein schwächeres Magnetfeld und an den Ausweitungen ein stärkeres Magnetfeld ausgebildet. Dadurch entsteht ein ungleichmässiger Wärmeeintrag in die zu verlötenden geraden Stromsammelschienen bzw. leitfähigen Bänder, wodurch die Stromsammelschienen unter Umständen nur entlang von Teilbereichen ausreichend stark mit den elektrisch leitfähigen Bändern verbunden werden können.

Ausgehend von dieser Problemstellung liegt der vorliegenden Erfindung die Aufgabe zugrunde, die genannten Nachteile zu vermeiden und eine Lötvorrichtung anzugeben, mit welcher besonders homogene magnetische Wechselfelder erzeugt werden könne. Darüber hinaus ist es Aufgabe der vorliegenden Erfindung, eine Lötvorrichtung anzugeben, welche ein magnetisches Wechselfeld hoher Feldstärke und Konzentration entlang der Lötlinie, d.h. entlang der geraden Stromsammelschiene bzw. des elektrisch leitfähigen Bandes, bereitstellt.

Diese Aufgabe wird gelöst durch eine Lötvorrichtung mit den Merkmalen des Patentanspruches 1.

Demnach zeichnet sich die erfindungsgemässe Lötvorrichtung dadurch aus, dass der Strompfad in einem elektrisch leitfähigen Festkörper ausgebildet ist und dieser Festkörper mindestens einen sich im Wesentlichen parallel zur Lötlinie erstreckenden Teil umfasst, welcher durch einen Luftspalt von der Lötlinie getrennt ist und in welchem mindestens ein Abschnitt des Strompfads ausgebildet ist. Der sich im Wesentlichen parallel zur Lötlinie erstreckende Teil weist mehrere Ausnehmungen auf, welche in einer Reihe hintereinander entlang der Lötlinie angeordnet sind. Die Ausnehmungen erstrecken sich entlang der Lötebene jeweils vertikal zur Lötlinie derart, dass jeweils eines der Niederhalterelemente bewegbar in einer der Ausnehmungen angeordnet ist. Der sich im Wesentlichen parallel zur Lötlinie erstreckende Teil umfasst mehrere längliche Abschnitte, von denen jeder eine sich parallel zur Lötlinie erstreckende Längsachse aufweist. Zwischen jeweils zwei der Ausnehmungen, welche in der einen Reihe unmittelbar hintereinander angeordnet sind, ist jeweils einer der länglichen Abschnitte angeordnet. Der jeweils eine zwischen den zwei Ausnehmungen angeordnete längliche Abschnitt erstreckt sich geradlinig und parallel zur Lötlinie von einer dieser zwei Ausnehmungen zur anderen dieser zwei Ausnehmungen. Insbesondere ist es bei der erfindungsgemässen Vorrichtung darüber hinaus vorgesehen, dass einer oder mehrere der länglichen Abschnitte Teil des Strompfads sind.

Die erfindungsgemässe Lötvorrichtung weist eine Vielzahl von Vorteilen auf. So ist es wegen der mehreren länglichen Abschnitte, von denen jeder eine sich parallel zur Lötlinie erstreckende Längsachse aufweist, möglich, ein sehr homogenes Magnetfeld entlang der gesamten Stromsammelschiene zur erzeugen. Insbesondere weist die erfindungsgemässe Lötvorrichtung damit keine wellenförmigen Schenkel auf, sondern erstreckt sich im Wesentlichen parallel zur Lötlinie. Somit kann die gerade Sammelschiene bzw. das elektrisch leitfähige Band vorzugsweise über die gesamte Länge möglichst gleichmässig erwärmt und das magnetische Wechselfeld besser auf das Band bzw. die Stromsammelschiene konzentriert werden. Auch ermöglicht die erfindungsgemässe Lötvorrichtung ein Bereitstellen von besonders hohen Stromstärken entlang der länglichen Abschnitte, wodurch starke magnetische Wechselfelder erzeugt werden können, die zu einer schnellen Erwärmung des elektrisch leitfähigen Bandes bzw. der Stromsammelschiene dienen. Weiterhin kann der elektrisch leitende Festkörper auf einfache weise mit hoher Präzision hergestellt werden, z.B. mittels spanabhebender Bearbeitung eines metallischen Körpers.

In einer Ausführungsform der erfindungsgemässen Lötvorrichtung ist vorgesehen, dass jeder der länglichen Abschnitte und/oder der mindestens eine sich im Wesentlichen parallel zur Lötlinie erstreckende Abschnitt des elektrisch leitfähigen Körpers und/oder der elektrisch leitfähige Festkörper symmetrisch zur Lötebene ausgebildet ist. Durch die symmetrische Ausbildung der vom Wechselstrom durchflossenen Teile der erfindungsgemässen Lötvorrichtung gegenüber der Lötebene ist es vorteilhafterweise möglich, ein besonders homogenes magnetisches Wechselfeld zu erzeugen, welches die Stromsammelschiene bzw. das elektrisch leitfähige Band durchsetzt. Auch kann durch die symmetrische Ausbildung der oben genannten Teile der Herstellungsprozess der erfindungsgemässen Lötvorrichtung stark vereinfacht werden.

Gemäss einer weiteren Ausführungsform der erfindungsgemässen Lötvorrichtung ist es vorgesehen, dass in zwei der Ausnehmungen, welche in der Reihe unmittelbar hintereinander angeordnet sind, zwei Niederhalterelemente in einem Abstand zueinander angeordnet sind, und sich der längliche Abschnitt zwischen diesen Ausnehmungen entlang der Lötlinie mit konstantem Querschnitt über eine Länge erstreckt, welche mindestens 50% des Abstands zwischen den zwei Niederhalterelementen beträgt. Weiterhin bestehen vorzugsweise mehr als 50% des mindestens einen sich im Wesentlichen parallel zur Lötlinie erstreckenden Teils aus den parallel zur Lötlinie ausgerichteten länglichen Abschnitten. Insbesondere ist es dabei vorteilhaft, wenn die länglichen Abschnitte einen prozentuellen Anteil von etwa 70% des mindestens einen sich im Wesentlichen parallel zur Lötlinie erstreckenden Teils ausmachen. Demnach ist ein Grossteil des Abschnitts des Strompfades, welcher durch den mindestens einen sich im Wesentlichen parallel zur Lötlinie erstreckenden Teil gebildet ist, durch die parallel zur Lötlinie ausgerichteten länglichen Abschnitte gebildet, wodurch eine besonders gleichmässige Erwärmung der zu verlötenden Teile der Solarzelle erreicht wird. Der konstante Querschnitt der länglichen Abschnitte verbessert zusätzlich die Homogenität des magnetischen Wechselfeldes. Die Querschnittsfläche kann vorzugsweise quadratisch sein und 1,5 mm x 1,5 mm betragen.

Gemäss einer weiteren Ausführungsform der erfindungsgemässen Lötvorrichtung ist es vorgesehen, dass die länglichen Abschnitte senkrecht zur Lötebene eine Dimension aufweisen, welche in etwa so gross ist wie eine Breite der Stromsammelschiene und/oder eine Breite des elektrisch leitfähigen Bandes senkrecht zur Lötebene. Mit anderen Worten, die länglichen Abschnitte können eine Breite aufweisen, welche in etwa der Breite der Stromsammelschiene und/oder der Breite des elektrisch leitfähigen Bandes entspricht. Dabei weisen die bekannten Stromsammelschienen bzw. die elektrisch leitfähigen Bänder typischerweise eine Breite von ca. 1 bis 3 mm auf. Gleichzeitig oder alternativ können die länglichen Abschnitte senkrecht zur Lötebene eine Dimension aufweisen, welche kleiner oder gleich einem Durchmesser eines der Niederhalterelemente senkrecht zur Lötebene ist. Dementsprechend stellen die länglichen Abschnitte der erfindungsgemässen Lötvorrichtung Einschnürungen entlang des sich im Wesentlichen parallel zur Lötlinie erstreckenden Teils dar, welche dazu dienen, hohe Stromdichten zu generieren, wodurch sehr starke magnetische Wechselfelder erzeugt werden können. Auch können die von dem im Wesentlichen parallel zur Lötlinie erstreckenden Teil erzeugten magnetischen Wechselfelder aufgrund der kleinen Dimensionen der länglichen Abschnitte sehr stark auf der Stromsammelschiene bzw. dem elektrisch leitfähigen Band konzentriert werden.

Nach einer weiteren Realisierung der erfindungsgemässen Lötvorrichtung sind die länglichen Abschnitte des im Wesentlichen parallel zur Lötlinie erstreckenden Teils des elektrisch leitfähigen Festkörpers in einer Reihe hintereinander entlang der Lötlinie angeordnet, wobei sich die Längsachsen der länglichen Abschnitte entlang einer parallel zur Lötlinie angeordneten Gerade erstrecken. Demnach wird ein besonders gerader Strompfad ausgebildet, welcher zu einem besonders homogenen magnetischen Wechselfeld, welches die Stromsammelschiene bzw. das elektrisch leitfähige Band durchsetzt, führt.

Nach einem weiteren Aspekt der erfindungsgemässen Lötvorrichtung ist es vorgesehen, dass der sich im Wesentlichen parallel zur Lötlinie erstreckende Teil des elektrisch leitfähigen Festkörpers mehrere, jeweils eine der Ausnehmungen umfassende Abschnitte aufweist, wobei diese Abschnitte in einer Reihe hintereinander entlang der Lötlinie angeordnet sind. Dabei sind jeweils zwei der jeweils eine der Ausnehmung umfassenden Abschnitte, welche in der Reihe unmittelbar hintereinander angeordnet sind, über einen der länglichen Abschnitte miteinander verbunden. Der die Ausnehmungen umfassende Abschnitt ist vorteilhafter Weise derart ausgebildet, dass die Ausnehmung bis auf kleinste Toleranzen an die Aussenkontur der Niederhalterelemente angepasst ist. Im Einzelnen bedeutet dies, dass die die Ausnehmungen umfassenden Abschnitte einen Durchmesser aufweisen, welcher nur minimal grösser als der Durchmesser der Niederhalterelemente (typischerweise 3 mm) ist. Somit ist es möglich, die Niederhalterelemente auf engstem Wege zu umschliessen und folglich eine möglichst geradlinige Stromführung entlang der Lötlinie zu gewährleisten. Die jeweiligen Ausnehmungen in dem sich im Wesentlichen parallel zur Lötlinie erstreckenden Teil des elektrisch leitfähigen Festkörpers können beispielsweise jeweils als eine durchgehende, sich im Wesentlichen vertikal zur Lötlinie erstreckende Bohrung, durch welche jeweils eines der Niederhalterelemente durchführbar ist, ausgebildet sein. Es ist allerdings auch vorstellbar, dass die Niederhalterelemente nicht in einer durchgehenden Bohrungen geführt sind, sondern jeweils in einer Nut, welche sich an einer Seite des sich im Wesentlichen parallel zur Lötlinie erstreckenden Teils des elektrisch leitfähigen Festkörpers im Wesentlichen vertikal zur Lötlinie erstreckt (beispielsweise jeweils an einem Ende eines der länglichen Abschnitte).

Gemäss einer weiteren Ausführungsform umfasst der elektrisch leitfähige Festkörper der erfindungsgemässen Lötvorrichtung mehrere sich vertikal zur Lötlinie erstreckende Abschnitte, welche jeweils auf einer von der Lötlinie abgewandten Seite des mindestens einen sich im Wesentlichen parallel zur Lötlinie erstreckenden Teils des elektrisch leitfähigen Festkörpers in einer Reihe hintereinander entlang der Lötlinie angeordnet sind. Jeder der sich vertikal zur Lötlinie erstreckenden Abschnitte ist an einer der Lötlinie zugewandten Seite zumindest mit einem Ende eines der länglichen Abschnitte verbunden. Die soeben erwähnten sich vertikal zur Lötlinie erstreckenden Abschnitte können vorteilhafter Weise dazu verwendet werden, die vorzugsweise sehr dünn ausgebildeten länglichen Abschnitte zu befestigen.

Besonders vorteilhaft ist es dabei, wenn zwei der sich vertikal zur Lötlinie erstreckenden Abschnitte, welche in der Reihe unmittelbar hintereinander angeordnet sind, durch einen sich vertikal zur Lötlinie erstreckenden Spalt getrennt und an ihren der Lötlinie zugewandten Seiten über einen der länglichen Abschnitte verbunden sind. Durch diese Anordnung wird gewährleistet, dass der zum Erzeugen des magnetischen Wechselfeldes benötigte Wechselstrom entlang des mindestens einen sich im Wesentlichen parallel zur Lötlinie erstreckenden Teils des elektrisch leitfähigen Festkörpers fliessen muss. Mit anderen Worten, die sich vertikal zur Lötlinie erstreckenden Abschnitte sind in der Regel nicht Teil des Strompfads des Wechselstroms. Die sich vertikal zur Lötlinie erstreckenden Abschnitte können ferner dazu genutzt werden, durch den Wechselstrom erzeugte Verlustwärme von den länglichen Abschnitten sowie den die Ausnehmungen umfassenden Abschnitten abzuführen.

Gemäss eines weiteren Aspekts der erfindungsgemässen Lötvorrichtung ist es vorgesehen, dass sich eine der Ausnehmungen durch mindestens einen der sich vertikal zur Lötlinie erstreckende Abschnitte erstreckt. Somit können die sich vertikal zur Lötlinie erstreckenden Abschnitte nicht nur dazu verwendet werden, den sich im Wesentlichen parallel zur Lötlinie erstreckenden Teil des elektrisch leitfähigen Festkörpers zu befestigen, sondern auch zur besseren Führung der Niederhalterelemente. Gemäss diesem Ausführungsbeispiel werden die Niederhalterelemente nicht nur durch die die Ausnehmungen umfassenden Abschnitte geführt, sondern ebenfalls durch die sich vertikal zur Lötlinie erstreckenden Abschnitte, woraus eine noch stabilere Führung der Niederhalterelemente entsteht.

Die sich vertikal zur Lötlinie erstreckenden Abschnitte sind gemäss einer weiteren vorteilhaften Ausführungsform symmetrisch zur Lötebene ausgebildet. Dies vereinfacht eine Montage der erfindungsgemässe Lötvorrichtung und hat andererseits zur Folge, dass eine optimale symmetrische Kühlung der erfindungsgemässen Lötvorrichtung vorgesehen werden kann. Mit Bezug auf die Kühlung der erfindungsgemässen Lötvorrichtung sei auch auf die weiteren Ausführungen verwiesen.

Gemäss einer weiteren Ausführungsform der erfindungsgemässen Lötvorrichtung kann diese Mittel zum Befestigen der sich vertikal zur Lötlinie erstreckenden Abschnitte aufweisen, um den elektrisch leitfähigen Festkörper in einer vorgegebenen Position relativ zur Solarzelle zu halten. Insbesondere können die vertikal zur Lötlinie erstreckenden Abschnitte dabei eine oder mehrere Öffnungen aufweisen, durch welche die sich vertikal zur Lötlinie erstreckenden Abschnitte über Befestigungsmittel (Schrauben, Stifte, Nieten) an einer Halterung bzw. Führung, angebracht werden kann. Somit kann die erfindungsgemässe Lötvorrichtung sehr einfach, beispielsweise an einer Führung angebracht werden, welche dazu dient, die Lötvorrichtung translatorisch zu verfahren und diese gegenüber der Stromsammelschiene bzw. dem elektrisch leitfähigen Band auszurichten. Darüber hinaus ist es denkbar, dass die erwähnten Mittel dazu genutzt werden können, Kühlkörper an den Seitenflächen der sich vertikal zur Lötlinie erstreckenden Abschnitte anzubringen, wie dies im Folgenden näher erläutert wird.

Wie bereits erwähnt, kann die erfindungsgemässe Lötvorrichtung optional auch eine Kühleinrichtung zum Kühlen mindestens eines der sich vertikal zur Lötlinie erstreckenden Abschnitte aufweisen. Dabei ist die Kühleinrichtung vorzugsweise derart ausgebildet, dass die länglichen Abschnitte des sich im Wesentlichen parallel zur Lötlinie erstreckenden Teils des elektrisch leitfähigen Festkörpers indirekt kühlbar sind mittels Wärmeleitung über den mindestens einen der sich vertikal zur Lötlinie erstreckenden Abschnitte, welcher mittels der Kühleinrichtung gekühlt werden kann. Dabei umfasst die Kühleinrichtung mindestens einen Kühlkörper, welcher mit mindestens einem der sich vertikal zur Lötlinie erstreckenden Abschnitte des elektrisch leitfähigen Festkörpers in einem thermischen Kontakt steht, wobei der mindestens eine Kühlkörper mittels eines Kühlfluids kühlbar ist. Dadurch, dass die länglichen Abschnitte des elektrisch leitfähigen Festkörpers der erfindungsgemässen Lötvorrichtung indirekt gekühlt werden, ist es nicht nötig, diese länglichen Abschnitte - wie aus dem Stand der Technik bekannt - mit Kühlflüssigkeit zu beschicken. Folglich ist es möglich, die länglichen Abschnitte des elektrisch leitfähigen Festkörpers der erfindungsgemässen Lötvorrichtung mit einem besonders geringen Durchmesser auszuführen, wodurch der elektrische Wechselstrom in den länglichen Abschnitten in vorteilhafter Weise sehr hohe Stromdichten erreichen kann. Es ist in diesem Zusammenhang weiterhin vorstellbar, dass der mindestens eine Kühlkörper der Kühleinrichtung mittels der oben genannten Mittel zum Befestigen der sich vertikal zur Lötlinie erstreckenden Abschnitte mit der Lötvorrichtung verbunden wird. Demzufolge ist es auf einfache Weise möglich, den mindestens einen Kühlkörper bei Bedarf auszutauschen bzw. komplett zu entfernen, falls es im speziellen Anwendungsfall keiner Kühlung bedarf.

Gemäss einer weiteren Ausführungsform kann der oben erwähnte mindestens eine Kühlkörper mit den sich vertikal zur Lötlinie erstreckenden Abschnitten des elektrisch leitfähigen Festkörpers über mindestens einen Isolationskörper verbunden sein. Dabei besteht der mindestens eine Isolationskörper vorzugsweise aus einem elektrisch isolierenden, wärmeleitenden Material. Alternativ kann sich statt des Isolationskörpers auch eine Beschichtung aus einem elektrisch isolierenden, wärmeleitenden Material zwischen dem mindestens einen Kühlkörper und dem mindestens einen der sich vertikal zur Lötlinie erstreckenden Abschnitte befinden. Hierbei kann die Beschichtung entweder auf der Oberfläche der sich vertikal zur Lötlinie erstreckenden Abschnitte des elektrisch leitfähigen Festkörpers und/oder auf dem mindestens einen Kühlkörper aufgebracht sein. Wie es mit Bezug auf die Figuren näher erläutert werden wird, kann durch den elektrisch isolierenden Isolationskörper bzw. die elektrisch isolierende Beschichtung die Stromein- bzw. Stromauskopplung auf besonders vorteilhafte Weise über Kühlfluideingänge erfolgen. Der Isolationskörper bzw. die Beschichtung sind vorzugsweise aus einem Werkstoff gebildet, welcher eine besonders hohe Wärmeleitfähigkeit bei einem möglichst hohen spezifischen Widerstand aufweisen. Insbesondere bevorzugt sind dabei Keramikwerkstoffe wie beispielsweise Aluminiumnitrid oder Bornitrid.

Gemäss einer besonders vorteilhaften Weiterbildung der vorstehend genannten Ausführungsform beträgt die Anzahl der Kühlkörper zwei, wobei diese zwei Kühlkörper aus einem elektrisch leitfähigen Material bestehen. Dabei ist vorzugweise der eine der zwei Kühlkörper mit einem Stromeinkopplungselement zum Einkoppeln des elektrischen Wechselstroms in den Strompfad verbunden, wobei dieser eine der zwei Kühlkörper ferner eine erste elektrische Verbindung zwischen sich und einem der vertikal zur Lötlinie erstreckenden Abschnitte des elektrisch leitfähigen Festkörpers aufweist. Der andere der zwei Kühlkörper ist mit einem Stromauskopplungselement zum Auskoppeln des elektrischen Wechselstroms aus dem Strompfad verbunden, wobei der andere der zwei Kühlkörper eine zweite elektrische Verbindung zwischen sich und einem anderen der sich vertikal zur Lötlinie erstreckenden Abschnitte des elektrisch leitfähigen Festkörpers aufweist. Das Stromeinkopplungselement und das Stromauskopplungselement können an einen Wechselstromgenerator angeschlossen werden, sodass ein von dem Wechselstromgenerator erzeugter Wechselstrom zwischen dem Stromeinkopplungselement und dem Stromauskopplungselement fliessen kann, wobei dieser Wechselstrom durch den elektrisch leitfähigen Festkörper der Induktionsantenne fliessen muss.

Bei dieser Ausführungsform sind jeweils zwei verschiedene der sich vertikal zur Lötlinie erstreckenden Abschnitte des elektrisch leitfähigen Festkörpers über die erste elektrische Verbindung bzw. die zweite elektrische Verbindung mit dem Stromeinkopplungselement bzw. dem Stromauskopplungselement elektrisch verbunden. In diesem Fall fliesst der elektrische Wechselstrom jeweils durch einen Abschnitt des sich im Wesentlichen parallel zur Lötlinie erstreckenden Teils des elektrisch leitfähigen Festkörpers, welcher sich zwischen den beiden sich vertikal zur Lötlinie erstreckenden Abschnitten erstreckt, welche über die erste elektrische Verbindung bzw. die zweite elektrische Verbindung mit dem Stromeinkopplungselement bzw. dem Stromauskopplungselement verbunden sind. Demnach ist die Länge des Abschnitts des sich im Wesentlichen parallel zur Lötlinie erstreckenden Teil des elektrisch leitfähigen Festkörpers, durch welchen der elektrische Wechselstrom fliesst, abhängig davon, mit welchem der sich vertikal zur Lötlinie erstreckenden Abschnitte des elektrisch leitfähigen Festkörpers der eine der Kühlkörper über die erste elektrische Verbindung verbunden ist und mit welchem anderen der sich vertikal zur Lötlinie erstreckenden Abschnitte des elektrisch leitfähigen Festkörpers der andere der Kühlkörper über die zweite elektrische Verbindung verbunden ist. Durch eine geeignete Wahl desjenigen der sich vertikal zur Lötlinie erstreckenden Abschnitte des elektrisch leitfähigen Festkörpers, welcher über die erste elektrische Verbindung mit dem einen der Kühlkörper verbunden ist, und eine entsprechende Wahl desjenigen der sich vertikal zur Lötlinie erstreckenden Abschnitte des elektrisch leitfähigen Festkörpers, welcher über die zweite elektrische Verbindung mit dem anderen der Kühlkörper verbunden ist, kann somit die Länge des Abschnitts des Strompfades, welcher durch den sich im Wesentlichen parallel zur Lötlinie erstreckenden Teil gebildet wird, auf einfache Weise ausgewählt und gegebenenfalls - je nach Bedarf - verändert werden. Dementsprechend kann durch die genannte Wahl eine "effektive Länge" der Induktionsantenne bestimmt werden. Die "effektive Länge" bezeichnet die Länge eines Abschnitts der Lötlinie, in welchem ein magnetisches Wechselfeld mittels der erfindungsgemässen Lötvorrichtung erzeugt wird. Diese "effektive Länge" kann jeweils geeignet gewählt und gegebenenfalls angepasst werden, abhängig von der Länge der Stromsammelschiene und der Länge des an der Stromsammelschiene zu befestigenden Bandes. Es sei an dieser Stelle erwähnt, dass die Begriffe "Stromeinkopplungselement" sowie "Stromauskopplungselement" lediglich zur einfacheren sprachlichen Differenzierung zwischen zwei elektrischen Kontakten gewählt wurden, über welche mittels eines Wechselstromgenerators ein elektrischer Wechselstrom in den Strompfad der Induktionsantenne ein- bzw. ausgekoppelt werden kann. Insbesondere sollten die beiden Begriffe "Stromeinkopplungselement" sowie "Stromauskopplungselement" nicht zu eng ausgelegt werden, da es sich selbstverständlich um Wechselströme handelt, weshalb die Richtung des Stromes in periodischen zeitlichen Abständen wechselt, sodass das Stromeinkopplungselement zum Stromauskopplungselement und das Stromauskopplungselement zum Stromeinkopplungselement wird. Dementsprechend sind in diesem Zusammenhang das jeweilige "Stromeinkopplungselement" und das jeweilige "Stromauskopplungselement" hinsichtlich einer Einkopplung des Wechselstroms in den Strompfad bzw. einer Auskopplung des Wechselstroms aus dem Strompfad äquivalent.

Nach einem weiteren Aspekt der Erfindung ist das bereits erwähnte Stromeinkopplungselement als eine aus einem elektrisch leitfähigen Material bestehende Kühlfluidleitung ausgebildet, durch welche Kühlfluid dem einen der zwei Kühlkörper zuführbar und/oder von dem einen der zwei Kühlkörper abführbar ist. Alternativ oder zusätzlich dazu kann das Stromauskopplungselement als eine aus einem elektrisch leitfähigen Material bestehende Kühfluidleitung ausgebildet sein, durch welche Kühlfluid dem anderen der zwei Kühlkörper zuführbar und/oder von dem anderen der zwei Kühlkörper abführbar ist. Zwar wird bei der erfindungsgemässen Lötvorrichtung der elektrische Wechselstrom, genau wie bei den aus dem Stand der Technik bekannten Lötvorrichtungen, über Kühlfluidleitungen in die Lötvorrichtung eingebracht und ausgetragen, jedoch trennt sich der Strompfad von dem Kühfluid-Pfad, sobald die Kühlfluidleitungen auf die Kühlkörper treffen. Somit wird eine effektivere Kühlung der erfindungsgemässen Lötvorrichtung erzielt, da der elektrische Wechselstrom im Wesentlichen nicht entlang der Kühlfluidleitungen verläuft und diese somit nicht unnötig durch seine Verlustwärme erhitzt.

Nach einer weiteren Ausführungsform der erfindungsgemässen Lötvorrichtung weist die oben erwähnte erste elektrische Verbindung ein erstes Kurzschlusselement auf, mit welchem ein elektrischer Kurzschluss zwischen dem ersten Kühlkörper und einem der sich vertikal zur Lötlinie erstreckenden Abschnitte des elektrisch leitfähigen Festkörpers herstellbar ist. Dieses Kurzschlusselement ist vorzugsweise an verschiedenen Positionen relativ zum ersten Kühlkörper montierbar, um einen elektrischen Kurzschluss zwischen jeweils verschiedenen der sich vertikal zur Lötlinie erstreckenden Abschnitte des elektrisch leitfähigen Körpers und dem ersten Kühlkörper herzustellen. Alternativ oder zusätzlich dazu kann die oben bereits erwähnte zweite elektrische Verbindung ein zweites Kurzschlusselement umfassen, mit welchem ein elektrischer Kurzschluss zwischen dem zweiten Kühlkörper und einem der sich vertikal zur Lötlinie erstreckenden Abschnitte des elektrisch leitfähigen Festkörpers herstellbar ist. Das zweite Kurzschlusselement ist vorzugsweise an verschiedenen Positionen relativ zum zweiten Kühlkörper montierbar, um einen elektrischen Kurzschluss zwischen dem jeweils anderen der sich vertikal zur Lötlinie erstreckenden Abschnitte des elektrisch leitfähigen Festkörpers und dem zweiten Kühlkörper herzustellen. Somit kann, wie oben bereits angedeutet, je nach Bedarf bzw. je nach Grösse der zu verlötenden Solarzelle die wirksame Länge des Strompfades verändert werden. Insbesondere ist es hierbei wiederum vorteilhaft, wenn die beiden Kurzschlusselemente aus einem Werkstoff hoher elektrischer Leitfähigkeit sowie hoher Wärmeleitfähigkeit bestehen. Durch die Kurschlusselemente ist es ohne Veränderung der erfindungsgemässen Lötvorrichtung stets möglich, die effektive Länge des Strompfades zu verändern.

Wie oben bereits erwähnt, ist die Kühleinrichtung lediglich als optional anzusehen. Insbesondere könnte die erfindungsgemässe Lötvorrichtung auch gänzlich ohne besagte Kühleinrichtung funktionieren, wobei dann der Wärmeabtransport ausschliesslich durch die sich vertikal von der Lötlinie erstreckenden Abschnitte des Festkörpers erfolgt. In diesem Zusammenhang ist es vorstellbar, dass mindestens einer der sich vertikal zur Lötlinie erstreckenden Abschnitte des elektrisch leitfähigen Festkörpers mit einer oder mehreren Kühllamellen versehen ist. Ferner könnte eine Vorrichtung zur Erzeugung eines Gasstroms vorgesehen sein, welche auf die jeweiligen Kühllamellen gerichtet ist oder entlang der jeweiligen Kühllamellen strömt, um diese zu kühlen.

Im Falle einer weiteren Ausführungsform der erfindungsgemässen Lötvorrichtung ist der elektrisch leitfähige Festkörper der Induktionsantenne derart ausgebildet, dass einer der länglichen Abschnitte des elektrisch leitfähigen Festkörpers eine Querschnittsfläche aufweist, deren Flächeninhalt grösser oder kleiner als der Flächeninhalt einer Querschnittsfläche mindestens eines anderen der länglichen Abschnitte des elektrisch leitfähigen Festkörpers ist. Dadurch, dass in diesem Fall verschiedene längliche Abschnitte des elektrisch leitfähigen Festkörpers unterschiedlich grosse Querschnittsflächen haben, wird erreicht, dass die Stromdichte des elektrischen Wechselstroms in dem sich im Wesentlichen parallel zur Lötlinie erstreckenden Teil des elektrisch leitfähigen Festkörpers entlang der Lötlinie variiert, sodass die Feldstärke des magnetischen Wechselfeldes, welche der Wechselstrom in der Lötlinie erzeugt, entlang der Lötlinie als Funktion des Ortes variiert. Alternativ oder zusätzlich kann eine Variation der Feldstärke des magnetischen Wechselfeldes entlang der Lötlinie auch dadurch erreicht werden, dass der Flächeninhalt der Querschnittsfläche eines oder mehrerer der länglichen Abschnitte des elektrisch leitfähigen Festkörpers in der Längsrichtung des jeweiligen länglichen Abschnitts variiert.

Bei einer weiteren Ausführungsform der erfindungsgemässen Lötvorrichtung umfasst die Induktionsantenne mehrere Ferrit-Körper, wobei jeder dieser Ferrit-Körper an einem der länglichen Abschnitte des elektrisch leitfähigen Festkörpers angeordnet ist und sich mindestens zwei dieser Ferrit-Körper hinsichtlich ihrer Form und/oder ihres Volumens und/oder ihrer magnetischen Permeabilität voneinander unterscheiden. Die jeweiligen Ferrit-Körper bewirken wegen ihrer relativ grossen magnetischen Permeabilität eine Verstärkung bzw. Konzentration des magnetischen Wechselfelds in ihrer Umgebung. Dadurch, dass mehrere Ferrit-Körper vorhanden sind und sich mindestens zwei dieser Ferrit-Körper hinsichtlich ihrer Form und/oder ihres Volumens und/oder ihrer magnetischen Permeabilität voneinander unterscheiden, wird erreicht, dass das magnetische Wechselfeld in verschiedenen Abschnitten der Lötlinie unterschiedlich stark konzentriert bzw. verstärkt wird, sodass die Feldstärke des magnetischen Wechselfeldes entlang der Lötlinie als Funktion des Ortes variiert. In einer Variante dieser Ausführungsform kann an die Stelle jedes der erwähnten Ferrit-Körper auch ein (entsprechend geformter und angeordneter) Körper aus einem magnetischen Material mit einer Permeabilitätszahl (relative Permeabilität) µᵣ>1 treten. Ein Körper aus einem derartigen magnetischen Material bewirkt ebenfalls eine Verstärkung bzw. Konzentration des magnetischen Wechselfelds in seiner Umgebung (analog zur Wirkung des jeweiligen Ferrit-Körpers).

Weitere Einzelheiten der Erfindung und insbesondere beispielhafte Ausführungsformen der erfindungsgemässen Vorrichtung und des erfindungsgemässen Verfahrens werden im Folgenden anhand der beigefügten Zeichnungen erläutert. Es zeigen:
- Fig. 1: eine perspektivische Darstellung von drei hintereinander geschalteten Solarzellen mit einer perspektivischen Frontansicht einer Ausführungsform der erfindungsgemässen Lötvorrichtung, mit einer Induktionsantenne und mehreren entlang einer geraden Lötlinie angeordneten Niederhalterelementen, welche jeweils mit einer Masse zum Niederhalten der Niederhalterelemente versehen sind;
- Fig. 2: eine perspektivische Rückansicht der in Fig. 1 dargestellten Ausführungsform der erfindungsgemässen Lötvorrichtung, jedoch ohne die in Fig. 1 dargestellten Massen zum Niederhalten der Niederhalterelemente;
- Fig. 3: eine Draufsicht auf den in Fig. 2 dargestellten Teil einer erfindungsgemässen Lötvorrichtung;
- Fig. 4: eine Explosionsdarstellung der in Fig. 1 darge- stellten Induktionsantenne der erfindungsgemässen Lötvorrichtung;
- Fig. 5: eine perspektivische Darstellung eines elektrisch leitfähigen Festkörpers der Induktionsantenne gemäss Fig. 2 mit einem im Festkörper ausgebildeten Strompfad für einen elektrischen Wechselstrom;
- Fig. 6: eine Seitenansicht des in Fig. 5 dargestellten elektrisch leitfähigen Festkörpers;
- Fig. 7A: eine vergrösserte Darstellung eines Segments des in Fig. 6 dargestellten elektrisch leitfähigen Festkörpers;
- Fig. 7B: eine vergrösserte Darstellung eines anderen Segments des in Fig. 6 dargestellten elektrisch leitfähigen Festkörpers;
- Fig. 8: einen Längsschnitt durch den in Fig. 6 dargestellten elektrisch leitfähigen Festkörpers;
- Fig. 9: eine detaillierte Seitenansicht eines sich parallel zur Lötlinie erstreckenden Teils des in den Figuren 5 und 6 dargestellten elektrisch leitfähigen Festkörpers;
- Fig. 10A: eine schematische Darstellung eines Strompfadabschnittes als Teil des Strompfads des elektrisch leitfähigen Festkörpers gemäss Fig. 5 und 6 mit einer ersten Länge des Strompfadabschnitts;
- Fig. 10B: eine schematische Darstellung eines Strompfadabschnittes als Teil des Strompfads des elektrisch leitfähigen Festkörpers gemäss Fig. 5 und 6 mit einer zweiten Länge des Strompfadabschnitts;
- Fig. 11: eine Draufsicht auf einen Teil der erfindungsgemässen Lötvorrichtung gemäss Fig. 3 mit schema- tisch angedeuteter Stromflussrichtung;
- Fig. 12: eine Seitenansicht der in Fig. 2 dargestellten Induktionsantenne;
- Fig. 13: Schnittdarstellungen entlang der in Fig. 12 dargestellten Schnittachsen A-A, B-B, C-C und D-D; und
- Fig. 14: eine vergrösserte Darstellung der in Fig. 13 dargestellten Schnittdarstellung entlang der Schnittachse B-B mit einer Solarzelle.
- Fig. 15: eine Induktionsantenne einer zweiten Ausführungsform der erfindungsgemässen Lötvorrichtung in einer Seitenansicht;
- Fig. 16: zwei Schnittdarstellungen der Induktionsantenne gemäss Fig. 15 entlang der Schnittachsen A-A und B-B;
- Fig. 17: vier Schnittdarstellungen der Induktionsantenne gemäss Fig. 15 entlang der Schnittachsen C-C, D-D, E-E und F-F.

In der folgenden detaillierten Figurenbeschreibung sind gleiche oder gleich wirkende Bauteile aus Gründen der Übersichtlichkeit mit gleichen Bezugszeichen versehen.

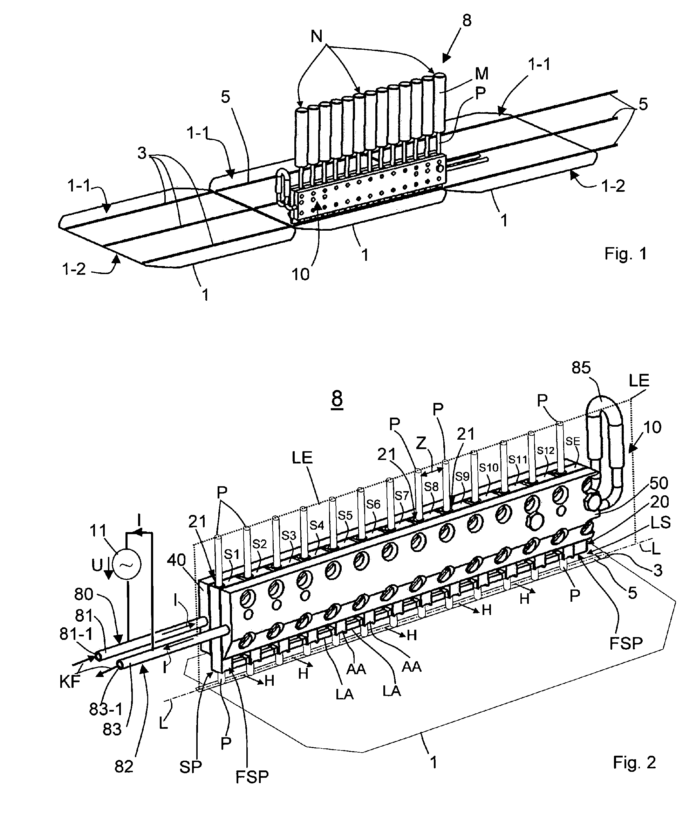

In Fig. 1 ist eine perspektivische Darstellung einer Ausführungsform der erfindungsgemässen Lötvorrichtung 8 mit drei hintereinander geschalteten Solarzellen 1 gezeigt. Im Einzelnen weist jede der Solarzellen 1 eine Oberseite 1-1 sowie eine Unterseite 1-2 auf, auf denen eine oder mehrere gerade Stromsammelschienen 3 angebracht sind. Aus dem Stand der Technik ist es bekannt, die Solarzellen 1 zu einem Band ("string") elektrisch zusammen zu schalten. Dazu werden die Leiterbahnen 3 auf der Oberseite 1-1 einer ersten Solarzelle 1 mit den Leiterbahnen (nicht explizit dargestellt) der Unterseite 1-2 einer zweiten Solarzelle 1 verbunden. Diese Verbindung erfolgt über elektrisch leitfähige Bänder 5, welche sich entlang der geraden Stromsammelschienen 3 von der Oberseite 1-1 der ersten Solarzelle 1 zur Unterseite 1-2 der zweiten Solarzelle 1 erstrecken und mit den jeweiligen Stromsammelschienen verlötet werden. Um ein Verlöten der elektrisch leitfähigen Bänder 5 mit den geraden Stromsammelschienen 3 zu ermöglichen, ist die Lötvorrichtung 8 derart ausgebildet, dass sie die jeweilige Stromsammelschiene 3 sowie das jeweilige elektrisch leitfähige Band 5 durch induktive Erwärmung aufheizt und dabei ein an den Stromsammelschienen 3 bzw. den Bändern 5 angebrachtes Lötmittel schmilzt, welches das elektrisch leitfähige Band 5 mit den Stromsammelschienen 3 verbindet. Zu diesem Zweck umfasst die Lötvorrichtung 8 eine Induktionsantenne 10, mit welcher ein magnetisches Wechselfeld erzeugbar ist, welches zum induktiven Erwärmen der jeweiligen Stromsammelschienen 3 bzw. Bänder 5 benötigt wird.

Um die elektrisch leitfähigen Bänder 5 während des Lötprozesses auf einer Oberfläche der geraden Stromsammelschienen 3 zu halten, sind bei der erfindungsgemässen Lötvorrichtung 8 mehrere (im vorliegenden Beispiel insgesamt 13) Niederhalter N vorgesehen, wobei jeder Niederhalter N ein Niederhalterelement P umfasst. Im vorliegenden Ausführungsbeispiel sind diese Niederhalterelemente P als Stifte ausgeführt, welche sich durch Ausnehmungen 21 (Fig. 2) in der Induktionsantenne 10 erstrecken, um eine senkrechte Kraftkomponente auf das elektrisch leitfähige Band 5 zu übertragen. Zum Beschweren der Niederhalterelemente P und damit zur Einstellung der von den Niederhalterelementen P auf das elektrisch leitfähige Band 5 übertragenen Kraftkomponente umfasst jeder Niederhalter N eine Masse M, welche mit dem von dem elektrisch leitfähigen Band 5 abgewandten Ende des jeweiligen Niederhalterelements P verbunden ist. Die Niederhalterelemente P sind vorzugsweise aus nicht magnetisierbaren Werkstoffen, beispielsweise Keramikwerkstoffen, gebildet.

Wie Fig. 2 zu entnehmen ist, weist die Induktionsantenne 10 der erfindungsgemässen Lötvorrichtung 8 einen sich entlang einer Lötlinie L erstreckenden Strompfads SP für einen elektrischen Wechselstrom I auf. Die Lötlinie L ist in diesem Zusammenhang als eine Linie zu verstehen, entlang welcher sich die mit der Lötvorrichtung 8 herzustellenden Lötverbindungen erstrecken sollen. Wie zu erkennen ist, handelt es sich bei der Lötlinie L um eine mathematische Gerade, welche insbesondere entlang bzw. durch die gerade Stromsammelschiene 3 verläuft. Der elektrische Wechselstrom I der in Fig. 2 dargestellten Induktionsantenne 10 ist derart entlang des Strompfades SP geführt, dass er in der Lötlinie L oder in einer Umgebung der Lötlinie L ein magnetisches Wechselfeld H erzeugt. Wie im Folgenden näher erläutert wird, wird durch die erfindungsgemässe Lötvorrichtung 8 ein magnetisches Wechselfeld H erzeugt, welches die gerade Stromsammelschiene 3 bzw. das elektrisch leitfähige Band 5 insbesondere horizontal (d.h. im Wesentlichen parallel zur Oberfläche der Stromsammelschiene 4) durchsetzt.

In Fig. 2 ist ferner eine Lötebene LE dargestellt, welche insbesondere senkrecht zu einer Ebene, in welcher die Solarzelle 1 liegt, ausgerichtet ist und entlang der Lötlinie L verläuft. Gleichzeitig bedeutet dies, dass die so definierte Lötebene LE parallel zur Lötlinie L ausgerichtet ist und dass die Lötlinie L in der Lötebene LE liegt. Wie gezeigt, sind auch die Niederhalterelemente P derart ausgebildet, dass sie sich jeweils senkrecht zur Lötlinie L und in der Lötlinie LE erstrecken, wobei die Niederhalterelemente P in einer Reihe hintereinander derart angeordnet sind, dass zwischen jeweils zwei der Niederhalterelemente P, welche in der Reihe unmittelbar hintereinander angeordnet sind, ein Zwischenraum Z ausgebildet ist. Es sei an dieser Stelle erwähnt, dass die jeweiligen Niederhalterelemente P derart angeordnet sind, dass sie in der Lötebene LE relativ zu der Lötlinie L insbesondere vertikal bewegbar sind.

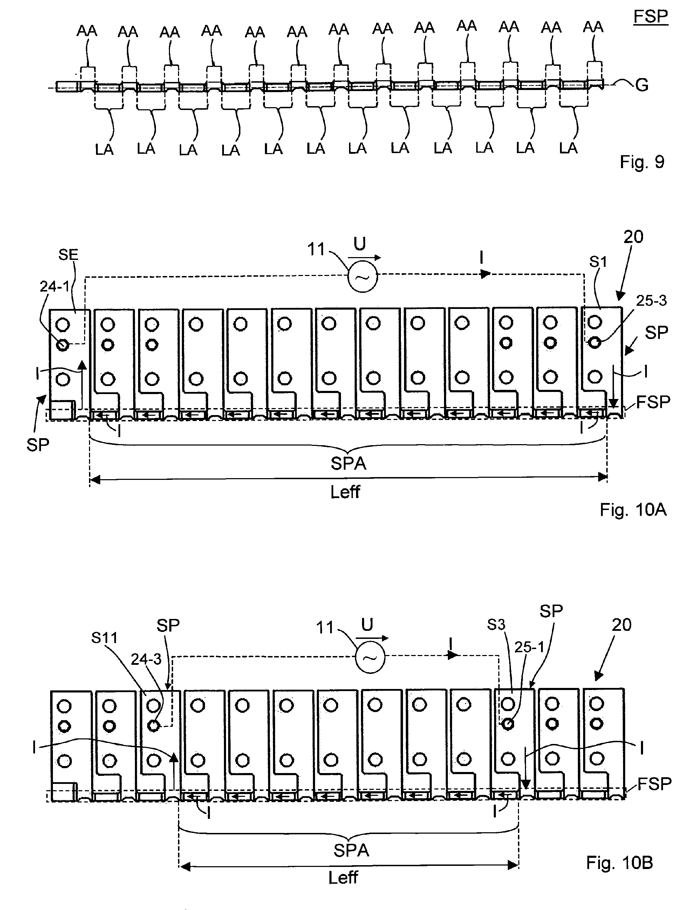

Wie aus Fig. 2 zu entnehmen ist, ist der Strompfad SP in einem elektrisch leitfähigen Festkörper 20 ausgebildet, wobei dieser Festkörper 20 mindestens einen sich im Wesentlichen parallel zur Lötlinie L erstreckenden Teil FSP umfasst. Der mindestens eine sich im Wesentlichen parallel zur Lötlinie L erstreckende Teil FSP ist durch einen Luftspalt LS von der Lötlinie L getrennt. Weiterhin ist - wie im Folgenden insbesondere im Zusammenhang mit Fig. 10A und 10B noch näher erläutert wird - in dem einen sich im Wesentlichen parallel zur Lötlinie erstreckenden Teil FSP mindestens ein Abschnitt des Strompfads SP ausgebildet (dieser Abschnitt des Strompfads SP ist in den Fig. 10A und 10B mit dem Bezugszeichen SPA versehen). Mit anderen Worten ist der sich im Wesentlichen parallel zur Lötlinie L erstreckende Teil FSP des Festkörpers 20 derart ausgebildet, dass der Wechselstrom I im Festkörper 20 zumindest auf einem Abschnitt des Strompfads SP durch den sich im Wesentlichen parallel zur Lötlinie erstreckenden Teil FSP des elektrisch leitfähigen Festkörpers 20 und damit im Wesentlichen geradlinig und parallel zur Lötlinie L fliessen muss.

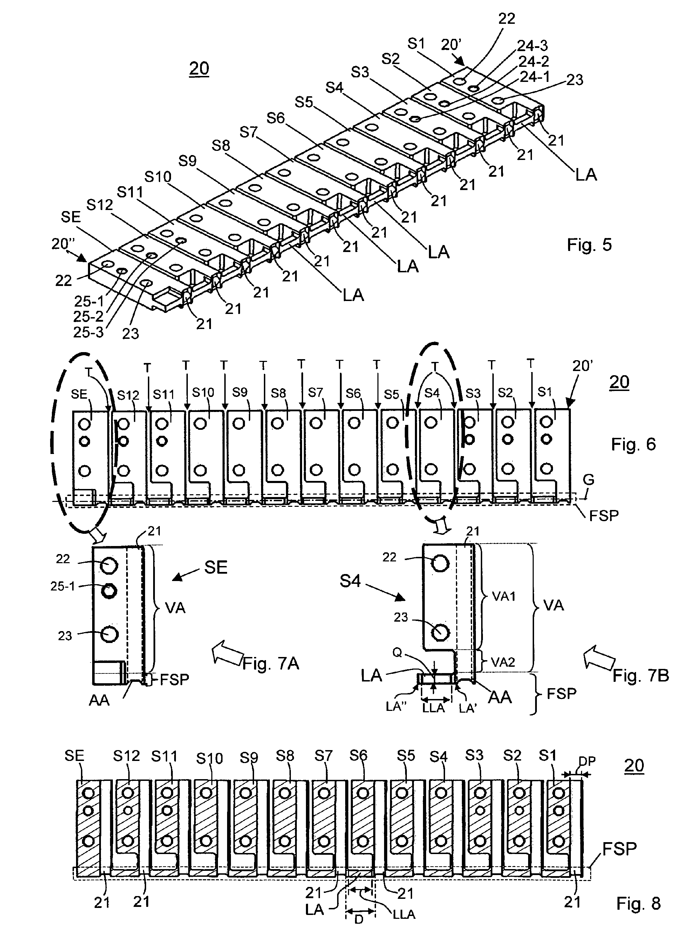

Weiterhin deutet Fig. 2 an, dass der elektrisch leitfähige Festkörper 20 im vorliegenden Beispiel insgesamt dreizehn Segmente S1-S12 und SE umfasst, welche in einer Reihe hintereinander entlang der Lötlinie L angeordnet sind. Jedes dieser Segmente S1-12 und SE umfasst eine der Ausnehmungen 21 für jeweils eines der Niederhalterelemente P. Im vorliegenden Beispiel ist jede der Ausnehmungen 21 als eine durch den elektrisch leitfähigen Festkörper 20 durchgehende Bohrung ausgebildet, welche sich in der Lötebene LE im Wesentlichen vertikal zur Lötlinie L erstreckt. Weitere konstruktive Einzelheiten des Festkörpers 20 werden noch im Folgenden insbesondere im Zusammenhang mit Fig. 5-9 erläutert.

Gemäss Fig. 2 umfasst die Lötvorrichtung 8 ein Stromeinkopplungselement 80 und ein Stromauskopplungselement 81. Das Stromeinkopplungselement 80 und das Stromauskopplungselement 81 können - wie Fig. 2 andeutet - an einen Wechselstromgenerator 11 angeschlossen werden, wobei das Stromeinkopplungselement 80 und das Stromauskopplungselement 82 elektrisch derart mit dem elektrisch leitfähigen Festkörper 20 verbunden sind, dass ein vom Wechselstromgenerator 11 erzeugter Wechselstrom I durch den Strompfad SP des Festkörpers 20 und insbesondere durch den sich im Wesentlichen parallel zur Lötlinie L erstreckenden Teil FSP des elektrisch leitfähigen Festkörpers 20 fliessen muss. Als Wechselstromgenerator 11 ist beispielsweise ein Wechselstromgenerator geeignet, welcher einen hochfrequenten Wechselstrom mit einer Frequenz im Bereich von beispielsweise 800-900 kHz erzeugt. Weitere konstruktive Einzelheiten des Stromeinkopplungselements 80 und des Stromauskopplungselements 82 werden im Folgenden noch erläutert.

Wie Fig. 2 weiterhin andeutet, kann die Lötvorrichtung 8 eine (optionale) Kühleinrichtung zur Kühlung des elektrisch leitfähigen Festkörpers 20 umfassen: In Fig. 2 ist ein erster Kühlkörper 40 und ein zweiter Kühlkörper 50 dargestellt. Der erste Kühlkörper 40 und der zweite Kühlkörper 50 erstrecken sich - in einem Abstand zueinander - jeweils in der Längsrichtung der Lötlinie L, wobei der elektrisch leitfähige Festkörper 20 zwischen diesen Kühlkörpern 40 und 50 derart angeordnet ist, dass einzelne Bereiche des Festkörpers 20 mit einem der Kühlkörper 40 bzw. 50 in thermischem Kontakt stehen. Weitere Einzelheiten zur (optionalen) Kühleinrichtung werden im Folgenden noch erläutert.

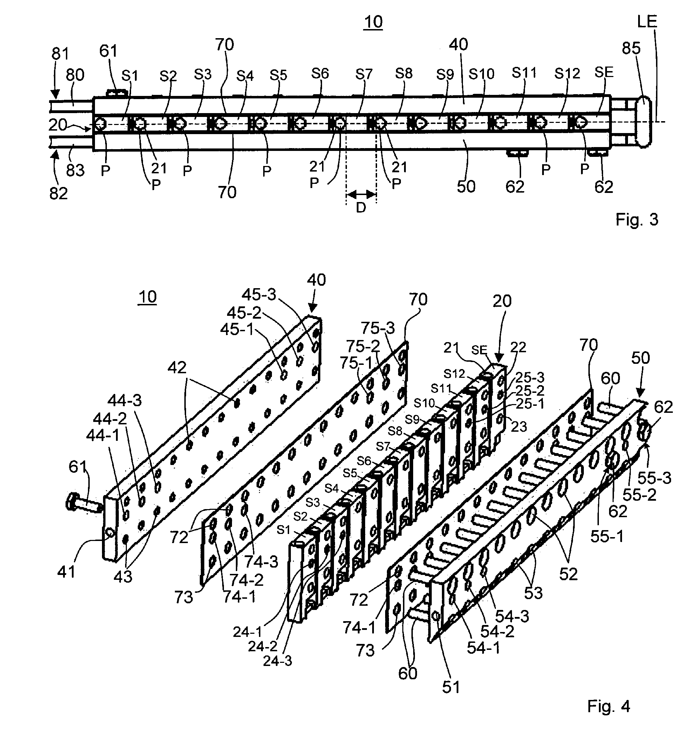

Fig. 4 zeigt einzelne Komponenten der Induktionsantenne 10 gemäss Fig. 2 in einer Explosionsdarstellung, wobei die jeweiligen Komponenten in einer zur Lötebene LE senkrechten Richtung voneinander separiert sind. Wie ersichtlich, umfasst die Induktionsantenne 10 zusätzlich zu dem elektrisch leitfähigen Festkörper 20, dem ersten Kühlkörper 40 und dem zweiten Kühlkörper 50 u.a. zwei Isolationskörper 70, welche aus einem elektrisch isolierenden Material gefertigt sind.

Einer dieser Isolationskörper 70 ist zwischen dem ersten Kühlkörper 40 und dem elektrisch leitfähigen Festkörper 20 angeordnet, um eine elektrisch Isolierung zwischen dem ersten Kühlkörper 40 und dem elektrisch leitfähigen Festkörper 20 zu bewirken. Der andere dieser Isolationskörper 70 ist zwischen dem zweiten Kühlkörper 50 und dem elektrisch leitfähigen Festkörper 20 angeordnet, um eine elektrisch Isolierung zwischen dem zweiten Kühlkörper 50 und dem elektrisch leitfähigen Festkörper 20 zu bewirken. Wie weiterhin aus Fig. 4 ersichtlich ist, umfasst die Induktionsantenne 10 gemäss Fig. 2 Befestigungsmittel 60, welche dazu dienen, den Festkörper 20, den ersten Kühlkörper 40, den zweiten Kühlkörper 50 und die Isolationskörper 70 mechanisch miteinander zu verbinden und derart zusammenzuhalten, dass die Induktionsantenne 10 eine Einheit bildet, welche als Ganzes in einer vorgegebenen Position bezüglich der Lötlinie L gehalten werden kann. Weiterhin umfasst die Induktionsantenne 10 ein Kurzschlusselement 61, welches dazu dient, eine elektrische Verbindung zwischen dem Stromeinkopplungselement 80 und dem Festkörper 20 herzustellen. Zusätzlich umfasst die Induktionsantenne 10 mindestens ein Kurzschlusselement 62, welches dazu dient, eine elektrische Verbindung zwischen dem Stromauskopplungselement 82 und dem Festkörper 20 herzustellen.

Wie bereits im Zusammenhang mit Fig. 2 angedeutet wurde, ist der elektrisch leitfähige Festkörper 20 der Induktionsantenne 10 aus Segmenten S1-S12 und SE zusammengesetzt, welche in einer Reihe hintereinander entlang der Lötlinie L angeordnet und miteinander verbunden sind. Die jeweilige Form und die Anordnung dieser Segmente S1-S12 und SE ist Fig. 5, 6, 7A, 7B und 8 entnehmbar. Wie weiterhin im Zusammenhang mit Fig. 2 erläutert wurde, umfasst der elektrisch leitfähige Festkörper 20 der Induktionsantenne 10 den sich im Wesentlichen parallel zur Lötlinie L erstreckenden Teil FSP. Wie Fig. 5, 6, 7A, 7B und 8 andeuten, besteht der sich im Wesentlichen parallel zur Lötlinie L erstreckende Teil FSP des Festkörpers 20 wiederum aus einzelnen Abschnitten der Segmente S1-S12 und SE, welche entlang der Lötlinie L in einer Reihe hintereinander angeordnet und miteinander verbunden sind. Zur Verdeutlichung dieses Sachverhalts ist in den Fig. 6 und 8 derjenige Abschnitt des Festkörpers 20, welcher den im Wesentlichen parallel zur Lötlinie L erstreckenden Teil FSP bildet, jeweils von einem mit gestrichelten Linien gezeichneten und mit dem Bezugszeichen FSP gekennzeichneten Rechteck umrahmt. Weiterhin ist der Teil FSP des Festkörpers 20 in Fig. 9 separat dargestellt.

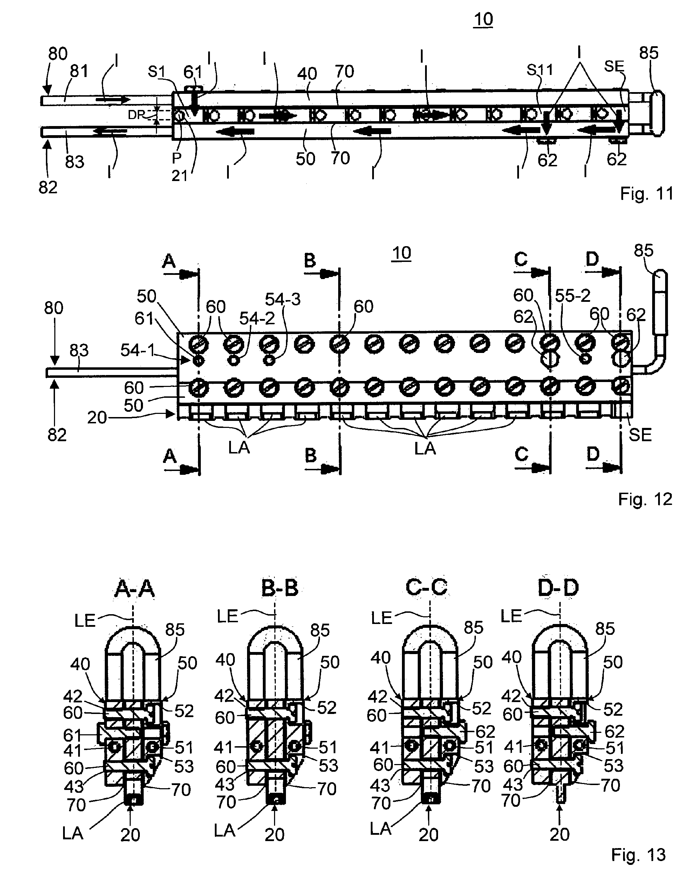

Mit Bezug auf die Fig. 5, 6, 8 und 9 sei erwähnt, dass die in Fig. 2 dargestellten Ausnehmungen 21 sich durch den sich im Wesentlichen parallel zur Lötlinie L erstreckende Teil FSP des Festkörpers 20 erstrecken, sodass der Teil FSP des Festkörpers 20 mehrere Ausnehmungen 21 aufweist, welche in einer Reihe hintereinander entlang der Lötlinie L angeordnet sind. Die Ausnehmungen 21 erstrecken sich in dem Teil FSP des Festkörpers 20 entlang der Lötebene LE jeweils vertikal zur Lötlinie L derart, dass jeweils eines der Niederhalterelemente P bewegbar in einer dieser Ausnehmungen 21 angeordnet ist. Die Ausnehmungen 21 sind dabei vorzugsweise bis auf kleinste Toleranzen auf die Ausmasse der Niederhalterelemente P angepasst, sodass die jeweilige Ausnehmung 21 einerseits einen möglichst kleinen Raum beansprucht und es andererseits ermöglicht, dass eines der Niederhalterelemente P in der jeweiligen Ausnehmung 21 relativ zur Lötlinie L bewegt werden kann. Typischerweise können die Ausnehmungen 21 dabei einen Durchmesser von etwas mehr als 3 mm aufweisen, sofern das jeweilige Niederhalterelement P - wie in Fig. 8 und 11 angedeutet - einen Durchmesser DP von 3 mm aufweisen sollte. Dadurch ist es möglich, die Ausnehmungen 21 möglichst klein auszubilden, wodurch der geradlinige Verlauf des Abschnitts des Strompfades SP, welcher durch den sich im Wesentlichen parallel zur Lötlinie erstreckenden Teil FSP des Festkörpers 20 verläuft, nur minimal verändert wird. Im Gegensatz zu den aus dem Stand der Technik bekannten Induktionsantennen, welche aus gebogenen Rohren gefertigt sind und deshalb an gekrümmten Abschnitten des jeweiligen Rohrs jeweils einen Biegeradius von mindestens 5 mm aufweisen, werden die Ausnehmungen 21 bei der erfindungsgemässen Lötvorrichtung 8 durch spanabhebende Bearbeitung (z.B. Fräsen, Bohren) eines Festkörpers gefertigt. Dadurch ist es insbesondere möglich, den im Wesentlichen geraden Verlauf des einen sich im Wesentlichen parallel zur Lötlinie L erstreckenden Teils FSP des Festkörpers 21 zu realisieren.

Weiterhin ist den Ausführungsformen der Figuren 2, 5, 8 und 9 zu entnehmen, dass der sich im Wesentlichen parallel zur Lötlinie L erstreckende Teil FSP des Festkörpers 20 mehrere längliche Abschnitte LA umfasst. Wichtig ist, dass jeder der mehreren länglichen Abschnitte LA eine sich parallel zur Lötlinie L erstreckende Längsachse aufweist. Jeweils einer dieser länglichen Abschnitte LA ist zwischen jeweils zwei der Ausnehmungen 21, welche in der einen Reihe unmittelbar hintereinander angeordnet sind, angeordnet und erstreckt sich geradlinig und parallel zur Lötlinie L von einer dieser zwei Ausnehmungen 21 zur anderen dieser zwei Ausnehmungen 21. Dementsprechend ist zumindest entlang der länglichen Abschnitte LA des sich im Wesentlichen parallel zur Lötlinie L erstreckenden Teils FSP ein vollkommen geradliniger, paralleler Verlauf des Wechselstromes I gegenüber der Lötlinie L gewährleistet. Bei der erfindungsgemässen Lötvorrichtung 8 ist stets mindestens einer der länglichen Abschnitte LA Teil des Strompfads SP.

Wie Fig. 2, 5, 6 und 9 zeigen, sind die länglichen Abschnitte LA des sich im Wesentlichen parallel zur Lötlinie L erstreckenden Teils FSP des elektrisch leitfähigen Festkörpers 20 in einer Reihe hintereinander entlang der Lötlinie L angeordnet, wobei sich die Längsachsen der länglichen Abschnitte LA entlang einer parallel zur Lötlinie L angeordneten Geraden G erstrecken. Die Gerade G bildet somit eine gemeinsame Längsachse für alle länglichen Abschnitte LA, wobei sich alle länglichen Abschnitte LA geradlinig entlang dieser gemeinsamen Längsachse erstrecken (Fig. 9). Der elektrische Wechselstrom I ist somit im Bereich der länglichen Abschnitte LA derart geführt, dass er parallel zur Geraden G bzw. zur Lötlinie L fliessen muss. Demzufolge ist der Strompfad SP des Wechselstroms in den länglichen Abschnitten LA parallel zur Geraden G ausgerichtet. Der sich im Wesentlichen parallel zur Lötlinie L erstreckenden Teils FSP des elektrisch leitfähigen Festkörpers 20 weist mehrere jeweils eine der Ausnehmungen 21 umfassende Abschnitte AA auf, wobei diese Abschnitte AA in einer Reihe hintereinander entlang der Lötlinie L angeordnet sind. Die jeweils eine der Ausnehmungen umfassenden Abschnitte AA sind insbesondere den Figuren 7A, 7B und 9 zu entnehmen. Besonders bevorzugt ist es, wenn die jeweils eine der Ausnehmungen 21 umfassenden Abschnitte AA genau auf die Ausmasse der Niederhalterelemente P angepasst sind. Somit ist Wechselstrom I lediglich in einem der Abschnitte AA des sich im Wesentlichen parallel zur Lötlinie L erstreckenden Teils FSP des Festkörpers nicht exakt parallel zur Geraden G bzw. zur Lötlinie L geführt. Demzufolge hat der Strompfad SP lediglich in einem der Abschnitte AA einen von der Geraden G abweichenden Verlauf. Letzteres stellt sich allerdings nicht als problematisch im Hinblick auf die Homogenität des mittels der Induktionsantenne erzeugbaren magnetischen Wechselfelds H heraus. Die Ausnehmungen 21 können so dimensioniert werden, dass sie sich in der Längsrichtung der Lötlinie L über eine Distanz erstrecken, welche verhältnismässig klein ist im Vergleich zur Erstreckung der jeweiligen länglichen Abschnitte LA in Längsrichtung der Lötlinie L. Dadurch, dass der Strom I den jeweiligen länglichen Abschnitten LA geradlinig und parallel zur Lötlinie L bzw. zur Geraden G geführt ist, kann ein fast perfekt homogener Verlauf des Magnetfelds H entlang der Stromsammelschienen 3 bzw. der elektrisch leitfähigen Bänder 5 erreicht werden. Im vorliegenden Beispiel sind die Ausnehmungen 21 als durchgehende Bohrungen ausgebildet. Alternativ ist es auch vorstellbar, die jeweilige Ausnehmung 21 als Nut auszubilden, welche sich derart relativ zur Lötlinie erstreckt, dass eines der Niederhalterelemente P in der Nut angeordnet und relativ zur Lötlinie bewegt werden kann.

Wie die Fig. 5, 6, 7A, 7B und 8 andeuten, kann der elektrisch leitfähige Festkörper 20 mehrere sich vertikal zur Lötlinie L erstreckende Abschnitte umfassen kann, welche im Folgenden mit dem Bezugszeichen VA bezeichnet werden sollen und insbesondere in den Fig. 6, 7A und 7B im Detail charakterisiert sind. Diese sich vertikal zur Lötlinie L erstreckenden Abschnitte VA sind insbesondere jeweils auf einer von der Lötlinie L abgewandten Seite des mindestens einen sich im Wesentlichen parallel zur Lötlinie L erstreckenden Teils FSP des elektrisch leitfähigen Festkörpers 20 in einer Reihe hintereinander entlang der Lötlinie L angeordnet. Jeder dieser Abschnitte VA des Festkörpers 20 bildet zusammen mit einem Abschnitt des sich im Wesentlichen parallel zur Lötlinie L erstreckenden Teils FSP des elektrisch leitfähigen Festkörpers 20 eines der Segmente S1-S12 und SE, welche bereits im Zusammenhang mit Fig. 2 erwähnt wurden. Wie Fig. 5, 6 und 8 zeigen, sind die Segmente S1-S12 und SE - in dieser Reihenfolge - in einer Reihe hintereinander angeordnet, wobei das Segment S1 ein erstes Ende 20' des Festkörpers 20 und das Segment SE ein zweites Ende 20" des Festkörpers 20 bildet.

Die Fig. 7A zeigt eine vergrösserte Darstellung des Segments SE, während die Fig. 7B eine vergrösserte Darstellung des Segments S4 zeigt. Die Segmente S1-S12 sind hinsichtlich ihrer Form und Funktion im Wesentlichen identisch, sodass die Fig. 7B am Beispiel des Segments S4 verschiedene Merkmale offenbart, welche für alle Segmente S1-S12 identisch sind. Wie Fig. 5 und 7A zeigen, bildet ein am Ende 20" angeordneter Abschnitt des sich im Wesentlichen parallel zur Lötlinie L erstreckenden Teils FSP des elektrisch leitfähigen Festkörpers 20 zusammen mit einem der sich vertikal zur Lötlinie L erstreckenden Abschnitte VA das Segment SE. Das Segment SE umfasst dabei einen der eine der Ausnehmungen 21 umfassenden Abschnitte AA des Teils FSP. Wie insbesondere Fig. 7B entnommen werden kann, umfasst das Segment S4 - und entsprechend jedes der Segmente S1-S3 und S5-S12 - einen der sich vertikal zur Lötlinie L erstreckenden Abschnitte VA und zusätzlich einen der eine der Ausnehmungen 21 umfassenden Abschnitte AA des Teils FSP und einen der länglichen Abschnitte LA, wobei der Abschnitt VA über den Abschnitt AA mit einem Ende LA' des länglichen Abschnitte LA verbunden ist. Wie Fig. 7B zeigt, ist das Ende LA' des länglichen Abschnitts LA des Segments S4 mit dem Abschnitt AA des Segments S4 verbunden. Entsprechendes gilt analog für den jeweiligen Abschnitt LA und den Abschnitt AA jedes der übrigen Segmente S1-S3 und S5-S12.

Wie Fig. 6 und Fig. 7A und 7B weiterhin andeuten, sind die Segmente S1-S12 und SE - ausgehend vom Ende 20' des Festkörpers 20 - in einer Reihe hintereinander derart angeordnet, dass ein Ende LA" des länglichen Abschnitts LA jedes einzelnen der Segmente S1-S12 mit dem Abschnitt AA des in der Reihe unmittelbar folgenden Segments verbunden ist. Ferner sind - wie Fig. 6 zeigt - die sich vertikal zur Lötlinie erstreckenden Abschnitte VA, welche in der Reihe unmittelbar hintereinander angeordnet sind, durch einen sich vertikal zur Lötlinie L erstreckenden Spalt T getrennt und an ihren der Lötlinie L zugewandten Seiten über einen der länglichen Abschnitte LA des mindestens einen sich im Wesentlichen parallel zur Lötlinie L erstreckenden Teils FSP des elektrisch leitfähigen Festkörpers 20 verbunden. Mit anderen Worten ist der Verlauf des Wechselstroms I von einem Segment S1, S2, ..., SE zum nächstliegenden Segment S1, S2, ..., SE ausschliesslich über einen der länglichen Abschnitte LA möglich, da die sich vertikal zur Lötlinie erstreckenden Abschnitte VA durch einen Spalt T gegeneinander isoliert sind. Auf diese Weise wird gewährleistet, dass der Wechselstrom I durch den sich im Wesentlichen parallel zur Lötlinie L erstreckenden Teils FSP des Festkörpers 20 fliessen muss, um entlang der Lötlinie L vom ersten Ende 20' des Festkörpers 20 zum zweiten Ende 20" des Festkörpers 20 (oder in der umgekehrten Richtung vom zweiten Ende 20" zum ersten Ende 20') zu gelangen.

Die sich vertikal zur Lötlinie erstreckenden Abschnitte VA der Segmente S1-S12 und SE haben, wie im Folgenden noch näher erläutert wird, mehrere Funktionen. Einerseits bieten die Abschnitte VA die Möglichkeit, den Festkörper 20 mittels geeigneter Befestigungsmittel an anderen Gegenständen zu befestigen: Zu diesem Zweck weisen die Segmente S1-S12 und SE beispielsweise Bohrungen 22 und 23 auf. Weiterhin besteht die Möglichkeit, den Wechselstrom I über die Segmente S1-S12 bzw. SE in den sich im Wesentlichen parallel zur Lötlinie L erstreckenden Teil FSP des elektrisch leitfähigen Festkörpers 20 einzukoppeln oder aus dem Teil FSP auszukoppeln. Zu diesem Zweck ist beispielsweise je eine Bohrung 25-1, 25-2 bzw. 25-3 in dem jeweiligen Abschnitt VA eines der Segmente SE, S12 bzw. S11 und je eine Bohrung 24-1, 24-2 bzw. 24-3 in dem jeweiligen Abschnitt VA eines der Segmente S3 bzw. S2 bzw. S2 ausgebildet (siehe Fig. 4, 5 und 7A). In die Bohrungen 25-1, 25-2, bzw. 25-3 und die Bohrungen 24-1, 24-2 bzw. 24-3 können die in Fig. 4 dargestellte Kurzschlussmittel 61 bzw. 62 eingesetzt werden, welche es erlauben, eine elektrische Verbindung zwischen dem Stromeinkopplungselement 80 bzw. dem Stromauskopplungselement 82 herzustellen (wie im Folgenden noch näher erläutert wird). Weiterhin ist es möglich (wie im Folgenden noch näher erläutert wird), über die jeweiligen Abschnitte VA der Segmente S1-S12 und SE mittels Wärmeleitung Wärme abzuführen, welche der Wechselstrom in den länglichen Abschnitten LA der Segmente S1-S12 und SE erzeugt.

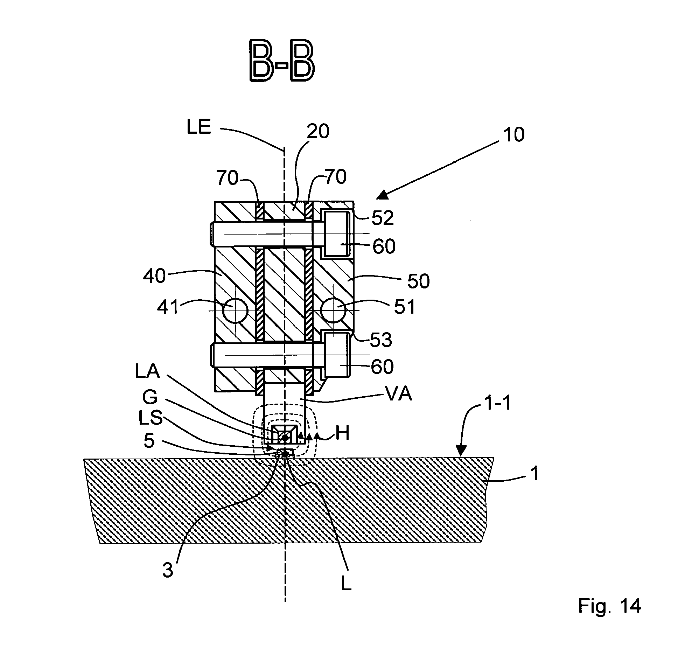

Zusätzlich können die sich vertikal zur Lötlinie erstreckenden Abschnitte VA, wie in Fig. 5, 7A, 7B und 8 gezeigt, derart ausgebildet sein, dass sich eine der Ausnehmungen 21 durch mindestens einen der Abschnitte VA erstrecken kann. Demzufolge weisen die Ausnehmungen 21 eine längere Ausdehnung auf, wodurch die Niederhalterelemente P stabiler innerhalb des elektrisch leitfähigen Festkörpers 20 geführt werden können. Ferner ist aus den Figuren 13 und 14 zu entnehmen, dass jeder der sich vertikal zur Lötlinie L erstreckenden Abschnitte VA symmetrisch zur Lötebene LE ausgebildet sein kann. Diese Ausführung der sich vertikal zur Lötlinie L erstreckenden Abschnitte VA kann im Hinblick auf eine Abfuhr von Verlustwärme, welche der Wechselstrom I in den länglichen Abschnitten LA erzeugt, und somit im Hinblick auf eine Kühlung der länglichen Abschnitte LA von Vorteil sein.

Um die vorstehend genannten Funktionen der Abschnitte VA realisieren zu können, können die Abschnitte VA im Vergleich zu den länglichen Abschnitten verhältnismässig gross ausgebildet werden. Zur Optimierung der Platzverhältnisse können die Abschnitte VA der Segmente S1-S12 beispielsweise jeweils in zwei Abschnitte VA1 und VA2 gegliedert sein, welche sich über unterschiedlich lange Distanzen in Richtung der Lötlinie L bzw. vertikal zur Lötlinie L erstrecken und vertikal zur Lötlinie in einer Reihe hintereinander angeordnet sind. Wie Fig. 7B zeigt, ist jeder der Abschnitte VA1 gross genug, um Platz sowohl für eine der Ausnehmungen 21 als auch für die Bohrungen 22 und 23 zu bieten. Der jeweilige Abschnitt VA2 bildet eine mechanische Verbindung zwischen einem der Abschnitte VA1 und einem der Abschnitte AA des sich im Wesentlichen parallel zur Lötlinie L erstreckenden Teils FSP des elektrisch leitfähigen Festkörpers 20 und ist hinsichtlich seiner Grösse derart ausgelegt, dass eine ausreichende Stabilität der genannten mechanischen Verbindung gewährleistet ist. Im vorliegenden Beispiel bietet der jeweilige Abschnitt VA2 auch zumindest Platz für eine der Ausnehmungen 21.

Den Darstellungen gemäss den Figuren 3 und 14 ist zu entnehmen, dass die erfindungsgemässe Lötvorrichtung 8 in vorteilhafter Weise derart ausgebildet ist, dass jeder der länglichen Abschnitte LA symmetrisch zur Lötebene L ausgebildet ist. Gleichwohl können der mindestens eine sich im Wesentlichen parallel zur Lötlinie L erstreckende Abschnitt FSP des elektrisch leitfähigen Festkörpers 20 und/oder der elektrisch leitfähige Festkörper 20 selbst symmetrisch zur Lötebene LE ausgebildet sein. Durch diese symmetrische Ausbildung der länglichen Abschnitte LA bzw. des Teils FSP des elektrisch leitfähigen Festkörpers 20 bezüglich der Lötebene LE wird in vorteilhafter Weise ein magnetisches Wechselfeld erzeugt, welches entlang der Lötlinie L besonders homogen ist und folglich die Stromsammelschiene 3 bzw. das elektrisch leitfähige Band 5 entlang der Lötlinie L besonders gleichmässig induktiv aufheizen kann. Deshalb kann beim Aufheizen eine besonders gleichmässige Temperaturverteilung entlang der Stromsammelschiene 3 bzw. entlang des elektrisch leitfähigen Bandes 5 erzeugt werden.

Nach einem weiteren Aspekt der erfindungsgemässen Lötvorrichtung sind in zwei der Ausnehmungen 21, welche in der Reihe unmittelbar hintereinander angeordnet sind, zwei Niederhalterelemente P, wie in Fig. 3 dargestellt, in einem Abstand D zueinander angeordnet. Wie in Fig. 7B gezeigt, erstreckt sich zwischen diesen zwei Ausnehmungen 21 der längliche Abschnitt LA entlang der Lötlinie L derart, dass der Querschnitt Q über eine Länge LLA konstant ist. Es ist dabei insbesondere vorteilhaft, wenn diese Länge LLA mindestens 50 Prozent des Abstands D zwischen den zwei Niederhalterelementen P beträgt. Vorzugsweise kann die Länge LLA mindestens 70 Prozent des Abstands D zwischen den zwei Niederhalterelementen P betragen. Dies ist von Vorteil im Hinblick auf die Homogenität des Magnetfelds H, welches mittels der Induktionsantenne 10 in der Lötlinie L in einem der Zwischenräume Z zwischen jeweils zwei der Niederhalterelemente P erzeugbar ist. In diesem Zusammenhang sei darauf hingewiesen, dass der Abstand D zwischen zwei unmittelbar hintereinander angeordneten Niederhalterelementen P beispielsweise 8-24 mm betragen kann. Gemäss der Erfindung kann der jeweilige Abschnitt LA somit im Wesentlichen sich über den genannten Abstand D geradlinig in der Lötebene LE parallel zur Lötlinie L erstrecken und dabei mindestens über eine (vom jeweiligen Abstand D abhängige) Distanz von 4-12 mm einen konstanten Querschnitt Q aufweisen (sofern der Parameter LLA mindestens 50 Prozent des Abstands D beträgt). Es sei darauf hingewiesen, dass entsprechende Werte mit einer aus EP 2 103 373 A1 bekannten, aus einem gebogenen Rohr gefertigten Induktionsantenne nicht erreichbar sind, zumal geeignete Rohre zur Herstellung derartiger Induktionsantennen in der Regel lediglich mit einem Biegeradius von mehr als 5 mm gebogen werden können.

In Fig. 14 ist eine Schnittdarstellung entlang der Schnittachse B-B gemäss Fig. 12 dargestellt. Hieraus ist zu erkennen, dass die länglichen Abschnitte LA der erfindungsgemässen Lötvorrichtung 8 senkrecht zur Lötebene LE eine Dimension aufweisen können, welche in etwa so gross ist wie eine Breite der Stromsammelschiene 3 und/oder eine Breite des elektrisch leitfähigen Bandes 5. Gleichzeitig können die länglichen Abschnitte LA senkrecht zur Lötebene LE eine Dimension aufweisen, welche kleiner oder gleich einem Durchmesser DP eines der Niederhalterelemente P ist. Somit kann durch die länglichen Abschnitte LA ein besonders stark konzentriertes magnetisches Wechselfeld mit hoher Feldstärke erzeugt werden. In Fig. 14 ist weiterhin der räumliche Verlauf mehrerer Feldlinien des magnetischen Wechselfeldes mittels gestrichelter Linien, welche den in Fig. 14 dargestellten länglichen Abschnitt LA jeweils in Form einer geschlossenen Kurve umgeben, schematisch skizziert. Die jeweiligen Feldlinien sind jeweils mit einer (in einem Fall mit dem Bezugszeichen H gekennzeichneten) Pfeilspitze versehen, welche die momentane Richtung des magnetischen Wechselfelds entlang der jeweiligen Feldlinie angibt, jeweils für die in Fig. 2 angegebene momentane Stromrichtung des elektrischen Wechselstroms I. Wie aus Fig. 14 ersichtlich, verlaufen die jeweiligen Feldlinien des magnetischen Wechselfeldes symmetrisch zur Lötebene LE. Dementsprechend ist das magnetische Wechselfeld in der Lötlinie L gemäss Fig. 14 senkrecht zur Lötebene LE und somit im Wesentlichen parallel zur Oberfläche 1-1 der Solarzelle 1 gerichtet.

Zurückkommend auf die Explosionsdarstellung gemäss Fig. 4 sei erwähnt, dass die erfindungsgemässe Lötvorrichtung 8 Mittel zum Befestigen der sich vertikal zur Lötlinie L erstreckenden Abschnitte VA aufweist, um den elektrisch leitfähigen Festkörper 20 in einer vorgegebenen Position relativ zur Solarzelle 1 zu halten. Im Einzelnen umfassen diese Mittel die Bohrungen 22, 23 in den Abschnitten VA der Segmente S1-S12 und SE, welche bereits im Zusammenhang mit Fig. 5, 7A und 7B erwähnt wurden, und die Befestigungsmittel 60, welche bereits im Zusammenhang mit Fig. 4 erwähnt wurden. Über die zuletzt genannten Befestigungsmittel 60 (z.B. Schrauben, Nieten, etc.) kann der erfindungsgemässe elektrisch leitfähige Festkörper 20 vorteilhafterweise an einer Führung angeordnet sein, welche dazu dient, den elektrisch leitfähigen Festkörper 20 und damit die erfindungsgemässe Lötvorrichtung 8 relativ zur Solarzelle 1 auszurichten. Wie es sich später herausstellen wird, ist es von Vorteil, die Befestigungsmittel 60 aus einem elektrisch isolierenden Werkstoff, beispielsweise Kunststoff, auszubilden.

Die erfindungsgemässe Lötvorrichtung 8 kann optional mit einer Kühleinrichtung zum Kühlen mindestens eines der sich vertikal zur Lötlinie L erstreckenden Abschnitte VA ausgestattet sein. Dabei sind die länglichen Abschnitte LA des sich im Wesentlichen parallel zur Lötlinie L erstreckenden Teils FSP des elektrisch leitfähigen Festkörpers 20 indirekt kühlbar, mittels Wärmeleitung über den mindestens einen der sich vertikal zur Lötlinie L erstreckenden Abschnitte VA, welcher mittels der Kühlreinrichtung gekühlt werden kann. Dazu kann die optionale Kühleinrichtung beispielsweise mindestens einen Kühlkörper 40 oder 50 (wie in Fig. 2-4, 13 und 14 dargestellt) umfassen, welcher mit mindestens einem der sich vertikal zur Lötlinie L erstreckenden Abschnitte VA des elektrisch leitfähigen Festkörpers 20 in einem thermischen Kontakt steht. Im Einzelnen ist es von Vorteil, wenn der mindestens eine Kühlkörper 40 oder 50 mittels eines Kühlfluids KF (Fig. 2) kühlbar ist. Durch die indirekte Kühlung der länglichen Abschnitte LA können diese in vorteilhafter Weise mit sehr kleinen Dimensionen ausgebildet werden, wodurch sehr hohe Stromdichten entlang der länglichen Abschnitte LA erzielbar sind. Wie bereits erwähnt, handelt es sich bei der Kühleinrichtung um ein optionales Merkmal der erfindungsgemässen Lötvorrichtung. Insbesondere ist es nämlich auch denkbar, dass der elektrisch leitfähige Festkörper 20 gänzlich ohne Kühleinrichtung ausgebildet ist. Gemäss dieser Ausführungsform (nicht dargestellt) kann der Wärmeabtransport beispielsweise lediglich durch die sich vertikal zur Lötlinie L erstreckenden Abschnitte VA erfolgen. Diese können dementsprechend beispielsweise in einer oder mehreren Kühllamellen zum verbesserten Wärmeabtransport versehen sein. Zusätzlich oder alternativ kann darüber hinaus eine Vorrichtung zur Erzeugung eines Gasstroms vorgesehen sein, welcher auf die jeweiligen Kühllamellen gerichtet ist oder entlang der jeweiligen Kühllamellen strömt.

Wieder in Bezug auf die in Fig. 4 dargestellte Kühleinrichtung mit mindestens einem Kühlkörper 40 oder 50 sei erwähnt, dass dieser Kühlkörper mit dem mindestens einen der sich vertikal zur Lötlinie L erstreckenden Abschnitte VA des elektrisch leitfähigen Festkörpers 20 verbunden sein kann. Diese Verbindung kann insbesondere durch die gleichen Mittel 22, 23, 60 erfolgen, welche - wie oben beschrieben - gleichzeitig dazu dienen, den elektrisch leitfähigen Festkörper 20 an einer Führung anzuordnen. Der Kühlkörper 40 weist dazu selbst Bohrungen 42 und 43 auf, welche mit den Bohrungen 22 und 23 im elektrisch leitfähigen Festkörper 20 korrespondieren und jeweils eines der Befestigungsmittel 60 aufnehmen können (der Kühlkörper 50 gemäss Fig. 4 weist Bohrungen 52 und 53 auf, welche mit den Bohrungen 22 und 23 im elektrisch leitfähigen Festkörper 20 korrespondieren und jeweils eines der Befestigungsmittel 60 aufnehmen können).

Wie zu erkennen ist, befindet sich zwischen dem mindestens einen Kühlkörper 40 oder 50 und dem Festkörper 20 mindestens ein Isolationskörper 70, welcher aus einem elektrisch isolierenden, wärmeleitenden Material gebildet ist. Selbstverständlich weist auch der Isolationskörper 70 Öffnungen 72, 73 zur Aufnahme der Befestigungsmittel 60 auf. Somit kann der mindestens eine Kühlkörper 40 oder 50 sowie der mindestens eine Isolationskörper 70 gleichzeitig mit denselben Befestigungsmitteln 60 an dem elektrisch leitfähigen Festkörper 20 befestigt werden. Alternativ zu dem Isolationskörper 70 ist es auch vorstellbar, dass eine Beschichtung aus einem elektrisch isolierenden, wärmeleitenden Material, welche auf dem mindestens einen der sich vertikal zur Lötlinie L erstreckenden Abschnitte VA des elektrisch leitfähigen Festkörpers 20 aufgebracht ist und/oder eine Beschichtung aus einem elektrisch isolierenden, wärmeleitenden Material, welche auf dem mindestens einen Kühlkörper 40 oder 50 aufgebracht ist, vorgesehen ist. Wegen des Isolationskörpers 70 bzw. der isolierenden Beschichtung ist es nicht möglich, dass durch den mindestens einen Kühlkörper 40 oder 50 ein ungewollter Kurzschluss zwischen den einzelnen Segmenten S1-S12 und SE des elektrisch leitenden Festkörpers 20 entsteht.

Wie in den Ausführungsbeispielen gemäss Fig. 2, 3, 11, 13 und 14 dargestellt, weist die Induktionsantenne 10 der erfindungsgemässen Lötvorrichtung 8 vorzugsweise zwei Kühlkörper 40 und 50 auf, wobei diese zwei Kühlkörper 40, 50 aus einem elektrisch leitfähigen Material bestehen und über jeweils einen der Isolationskörper 70 mit den Abschnitten VA des Festkörpers 20 in thermischen Kontakt stehen. Im Hinblick auf Fig. 2, 3 und 11 lässt sich erkennen, dass das bereits erwähnte Stromeinkopplungselement 80 zum Einkoppeln des elektrischen Wechselstroms I in den Strompfad SP mit dem Kühlkörper 40 verbunden ist. Die erfindungsgemässe Lötvorrichtung 8 weist darüber hinaus eine erste elektrische Verbindung 61 zwischen dem Kühlkörper 40 und einem der sich vertikal zur Lötlinie L erstreckenden Abschnitte VA des elektrisch leitfähigen Festkörpers 20 auf. Die elektrische Verbindung 61 dient dabei insbesondere dazu, den elektrischen Wechselstrom I von dem Kühlkörper 40 in den Festkörper 20 einzuleiten. Da die Kühlkörper 40, 50 insbesondere durch die Isolationskörper 70 isolierend von dem Festkörper 20 getrennt sind, ist ein Übergang des elektrischen Wechselstroms I von dem Kühlkörper 40 auf den Festkörper 20 lediglich an der Stelle der ersten elektrischen Verbindung 61 möglich.

Wie es ferner Fig. 2, 3 und 11 zu entnehmen ist, ist das bereits erwähnte Stromauskopplungselement 82 zum Auskoppeln des elektrischen Wechselstroms I aus dem Strompfad SP mit dem zweiten Kühlkörper 50 verbunden ist. Analog zur ersten elektrischen Verbindung 61, weist die erfindungsgemässe Lötvorrichtung 8 auch eine zweite elektrische Verbindung 62 zwischen dem zweiten Kühlkörper 50 und einem anderen der sich vertikal zur Lötlinie L erstreckenden Abschnitte VA des elektrisch leitfähigen Festkörpers 20 auf. Ähnlich wie die erste elektrische Verbindung 61, dient die zweite elektrische Verbindung 62 dazu, den elektrischen Wechselstrom I vom Festkörper 20 auf den Kühlkörper 50 überzuleiten. In dem in Fig. 2, 3 und 11-13 dargestellten Beispiel ist das Stromeinkopplungselement 80 über die erste elektrische Verbindung 61 mit dem Abschnitt VA des Segments S1 verbunden, während das Stromauskopplungselement 82 über jeweils eine zweite elektrische Verbindung 62 mit dem Abschnitt VA des Segments S11 und mit dem Abschnitt VA des Segments SE verbunden ist.

Das mit Bezug auf Fig. 11 beschriebene Ausführungsbeispiel stellt eine besonders vorteilhafte Möglichkeit dar, den elektrischen Wechselstrom I in den Strompfad des Festkörpers 20 einzuleiten. Da es sich hier um elektrischen Wechselstrom I handelt, sind die Begriffe Stromeinkopplungselement 80 sowie Stromauskopplungselement 82 derart auszulegen, dass bei einer Umkehr der Stromrichtung des von dem Wechselstromgenerator 11 erzeugten Wechselstroms I das Stromeinkopplungselement 80 die Funktion des Stromauskopplungselements 82 übernimmt und das Stromauskopplungselement 82 die Funktion des Stromeinkopplungselements 80 übernimmt.

Nach einem weiteren Aspekt der erfindungsgemässen Lötvorrichtung 8 ist das Stromeinkopplungselement 80 als eine aus einem elektrisch leitfähigen Material bestehende Kühlfluidleitung 81 ausgebildet, wobei durch die Kühlfluidleitung 81 Kühlfluid KF dem Kühlkörper 40 zuführbar und/oder von dem Kühlkörper 40 abführbar ist (wie in Fig. 2 mittels eines mit KF bezeichneten Pfeils angedeutet ist). Darüber hinaus kann das Stromauskopplungselement 82 als eine aus einem elektrisch leitfähigen Material bestehende Kühlfluidleitung 83 ausgebildet sein, wobei durch die Kühlfluidleitung 83 Kühlfluid KF dem Kühlkörper 50 zuführbar und/oder von dem Kühlkörper 50 abführbar ist (wie in Fig. 2 mittels eines mit KF bezeichneten Pfeils angedeutet ist). Dabei mündet die Kühlfluidleitung 81 in einen im Kühlkörper 40 ausgebildeten Kühlkanal 41, welcher sich entlang der Lötlinie L von einem Ende des Kühlkörpers 40 zum anderen Ende des Kühlkörpers 40 erstreckt. Entsprechend mündet die Kühlfluidleitung 83 in einen im Kühlkörper 50 ausgebildeten Kühlkanal 51, welcher sich entlang der Lötlinie L von einem Ende des Kühlkörpers 50 zum anderen Ende des Kühlkörpers 50 erstreckt. Die beiden Kühlkanäle 41 und 51 können dabei insbesondere am anderen Ende der beiden Kühlkörper 40 und 50 über eine (elektrisch isolierende) Verbindungsleitung 85 miteinander verbunden sein. Dadurch ist es möglich, die beiden Kühlkörper 40, 50 mit einem Kühlfluidkreislauf zu versorgen. Selbstverständlich ist es jedoch auch denkbar, dass jeder der beiden Kühlkörper 40, 50 einen eigenen Külfluidkreislauf aufweist.

Nach einer weiteren Ausführungsform der erfindungsgemässen Lötvorrichtung kann vorteilhafter Weise eine "effektive Länge" Leff des mindestens einen Abschnitts des Strompfades SP, welcher in dem einen sich im Wesentlichen parallel zur Lötlinie L erstreckenden Teil FSP des Festkörpers 21 ausgebildet ist, individuell eingestellt werden. Dazu umfasst die erste elektrische Verbindung ein erstes Kurzschlusselement 61, mit welchem ein elektrischer Kurzschluss zwischen dem ersten Kühlkörper 40 und einem der sich vertikal zur Lötlinie L erstreckenden Abschnitte VA des elektrisch leitfähigen Festkörpers 20 herstellbar ist. Dieses Kurzschlusselement 61 ist vorteilhafterweise an verschiedenen Positionen 44-1, 44-2, 44-3, 45-1, 45-2, 45-3 relativ zum ersten Kühlkörper 40 montierbar, um einen elektrischen Kurzschluss zwischen jeweils verschiedenen der sich vertikal zur Lötlinie L erstreckenden Abschnitte VA des elektrisch leitfähigen Festkörpers 20 und dem ersten Kühlkörper 40 herzustellen. Darüber hinaus kann die zweite elektrische Verbindung ein zweites Kurzschlusselemente 62 umfassen, mit welchem ein elektrischer Kurzschluss zwischen dem zweiten Kühlkörper 50 und einem der sich vertikal zur Lötlinie L erstreckenden Abschnitte VA des elektrisch leitfähigen Festkörpers 20 herstellbar ist. Dieses zweite Kurzschlusselement 62 ist wiederum an verschiedenen Positionen 54-1, 54-2, 54-3, 55-1, 55-2, 55-3 relativ zum zweiten Kühlkörper 50 montierbar, um einen elektrischen Kurzschluss zwischen jeweils verschiedenen der sich vertikal zur Lötlinie L erstreckenden Abschnitte VA des elektrisch leitfähigen Festkörpers 20 und dem zweiten Kühlkörper 50 herzustellen.

Mit Bezug auf Fig. 4 sei erwähnt, dass die beiden Kühlkörper 40, 50 an oben erwähnten, verschiedenen Positionen 44-1, 44-2, 44-3, 45-1, 45-2, 45-3, 54-1, 54-2, 54-3, 55-1, 55-2, 55-3 Bohrungen aufweisen können, durch welche die elektrischen Kurzschlusselemente 61, 62 geführt werden können. Selbstverständlich ist es in diesem Zusammenhang auch vorgesehen, dass der mindestens eine Isolationskörper 70 sowie der Festkörper 20 eine entsprechende Anzahl an Bohrungen 74-1, 74-2, 74-3, 75-1, 75-2, 75-3 bzw. 24-1, 24-2, 24-3, 25-1, 25-2, 25-3 aufweisen, um die erfindungsgemässen Kurzschlusselemente 61, 62 darin aufzunehmen. Wie es in den Figuren 10A, 10B bzw. 11 schematisch angedeutet ist, kann durch das Einsetzen der Kurzschlusselemente 61, 62 an verschiedenen Positionen 24-1, 24-2, 24-3, 25-1, 25-2, 25-3 entlang des Festkörpers 20 die Länge des eines Abschnitts des Strompfades SP welcher in dem sich im Wesentlichen parallel zur Lötlinie L erstreckenden Teil FSP ausgebildet ist, auf den jeweiligen Anwendungsfall eingestellt werden. Fig. 10A stellt beispielsweise den Strompfad SP des Wechselstroms I im Festkörper 20 für den Fall dar, dass ein Kurzschlusselement 61 in die Bohrung 24-1 im Segment SE des Festkörpers 20 und ein Kurzschlusselement 62 in die Bohrung 25-3 des Segments S1 des Festkörpers 20 eingesetzt ist. In diesem Fall ist der Wechselstromgenerator 11 folglich derart mit dem Festkörper 20 verbunden, dass der Wechselstrom I über die Segmente SE und S1 in den sich im Wesentlichen parallel zur Lötlinie L erstreckenden Teil FSP des Festkörpers 20 einkoppelbar bzw. aus diesem Teil FSP auskoppelbar ist. In Fig. 10A ist mit "SPA" ein Abschnitt des Strompfads SP des Wechselstroms I bezeichnet, in welchem der Wechselstrom I durch den sich im Wesentlichen parallel zur Lötlinie L erstreckenden Teil FSP des Festkörpers 20 fliesst. Dementsprechend erzeugt der Wechselstrom I entlang dieses Abschnitts SPA ein magnetisches Wechselfeld an der Lötlinie L. Der Abschnitt SPA des Strompfads SP erstreckt sich in diesem Fall durch alle länglichen Abschnitt LA der Segmente S1-S12. Der mit Leff bezeichnete Pfeil in Fig. 10A kennzeichnet dementsprechend die "effektive Länge" der Induktionsantenne, d.h. die Länge eines Abschnitts der Lötlinie L, in dem mittels der Induktionsantenne ein magnetisches Wechselfeld erzeugbar ist.

Gemäss einem anderen Beispiel stellt Fig. 10B den Strompfad SP des Wechselstroms I im Festkörper 20 für den Fall dar, dass ein Kurzschlusselement 61 in die Bohrung 24-3 im Segment S11 des Festkörpers 20 und ein Kurzschlusselement 62 in die Bohrung 25-1 des Segments S3 des Festkörpers 20 eingesetzt ist. In diesem Fall ist der Wechselstromgenerator 11 folglich derart mit dem Festkörper 20 verbunden, dass der Wechselstrom I über die Segmente S11 und S3 in den sich im Wesentlichen parallel zur Lötlinie L erstreckenden Teil FSP des Festkörpers 20 einkoppelbar bzw. aus diesem Teil FSP auskoppelbar ist. In Fig. 10B ist mit "SPA" ein Abschnitt des Strompfads SP des Wechselstroms I bezeichnet, in welchem der Wechselstrom I in diesem Fall durch den sich im Wesentlichen parallel zur Lötlinie L erstreckenden Teil FSP des Festkörpers 20 fliesst. Dementsprechend erzeugt der Wechselstrom I entlang dieses Abschnitts SPA ein magnetisches Wechselfeld an der Lötlinie L. Der Abschnitt SPA des Strompfads SP erstreckt sich in diesem Fall durch alle länglichen Abschnitt LA der Segmente S3-S11. Der mit Leff bezeichnete Pfeil in Fig. 10A kennzeichnet dementsprechend die "effektive Länge" der Induktionsantenne für diesen Fall. Die effektive Länge Leff ist im Beispiel gemäss Fig. 10B offensichtlich kürzer als im Beispiel gemäss Fig. 10A.

Somit ist das durch den Abschnitt SPA des Strompfades erzeugte magnetische Wechselfeld H auf die jeweilige Grösse der Solarzelle 1 anpassbar. Selbstverständlich ist die Anzahl der verschiedenen Positionen 24-1, 24-2, 24-3, 25-1, 25-2, 25-3 nicht auf die dargestellte Anzahl beschränkt, sondern kann insbesondere der Anzahl der sich vertikal zur Lötlinie L erstreckenden Abschnitte VA des elektrisch leitfähigen Festkörpers 20 entsprechen.

Hinsichtlich der oben erwähnten ersten und zweiten Kurzschlusselemente 61, 62 sei mit Bezug auf die in den Figuren 1-14 dargestellten Ausführungsbeispiele darauf hingewiesen, dass selbstverständlich nur eines der beiden in den Figuren dargestellten zweiten Kurzschlusselemente 62 (siehe beispielsweise Fig. 12) für den Betrieb der erfindungsgemässen Lötvorrichtung 8 benötigt wird.

Gemäss einer weiteren Variante der in Fig. 2 dargestellten Ausführungsform der Induktionsantenne 10A ist es auch denkbar, den vom Wechselstromgenerator 11 erzeugten elektrischen Wechselstrom I nicht über die Kühlfluidleitungen 81 und 83 in den Festkörper 20 einzukoppeln bzw. aus dem Festkörper 20 auszukoppeln. Alternativ kann der elektrische Wechselstrom auch direkt über die Kühlkörper 40 und 50 ein- bzw. ausgekoppelt werden. Beispielsweise kann der Wechselstromgenerator 11 zur Einkopplung bzw. Auskopplung des Wechselstroms auch direkt mit den Kühlkörpern 40 und 50 elektrisch verbunden werden. Da der Festkörper 20 über die Kurzschlusselemente 61 und 62 mit den Kühlkörpern 40 und 50 verbunden ist, können zu diesem Zweck im Prinzip beliebige Bereiche der Kühlkörper 40 und 50 mit dem Wechselstromgenerator 11 elektrisch verbunden werden. Beispielsweise kann der Kühlkörper 40 auch an einem von der Kühlmittelleitung 81 abgewandten Ende und der Kühlkörper 50 an einem von der Kühlmittelleitung 83 abgewandten Ende elektrisch mit dem Wechselstromgenerator 11 verbunden werden.

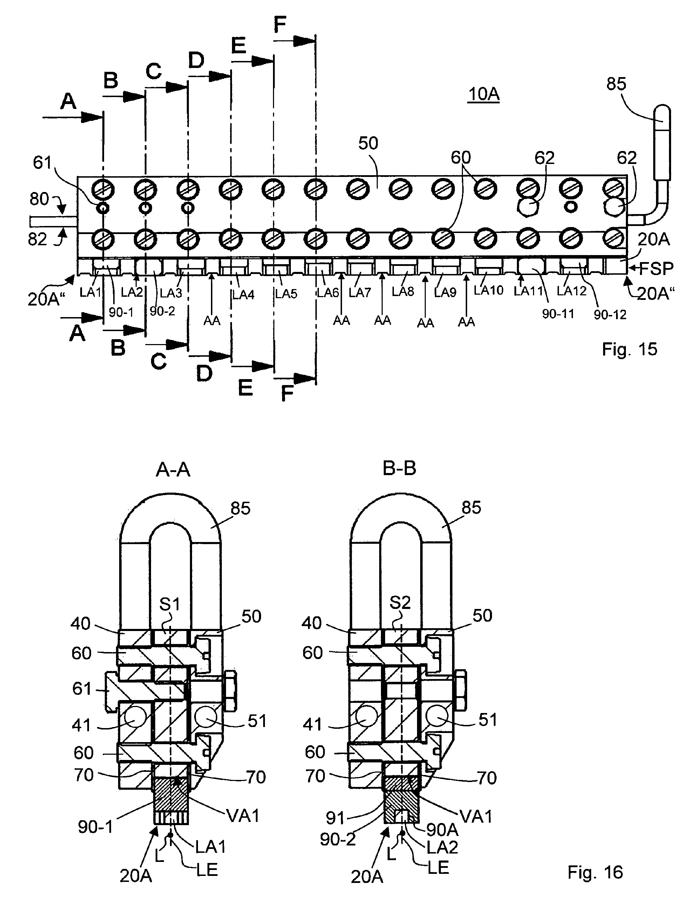

Fig. 15-17 zeigen eine Induktionsantenne 10A einer zweiten Ausführungsform der erfindungsgemässen Lötvorrichtung, welche eine Variante der in Fig. 1 und 2 dargestellten Lötvorrichtung 8 ist und sich von der Lötvorrichtung 8 gemäss Fig. 1 und 2 im Wesentlichen dadurch unterscheidet, dass die Induktionsantenne 10 gemäss Fig. 1-14 durch die Induktionsantenne 10A gemäss Fig. 15-17 ersetzt ist. Die Induktionsantenne 10A ist hinsichtlich einer Reihe konstruktiver Einzelheiten identisch mit der Induktionsantenne 10 gemäss Fig. 1-14, wobei Bauteile der jeweiligen Induktionsantennen 10A bzw. 10, welche hinsichtlich ihrer Konstruktion oder ihrer Funktion identisch sind, in den Fig. 1-17 gegebenenfalls mit identischen Bezugszeichen versehen sind. Im Folgenden werden deshalb im Wesentlichen die Unterschiede zwischen den Induktionsantennen 10A und 10 erläutert.

Die Induktionsantenne 10A unterscheidet sich von der Induktionsantenne 10 im Wesentlichen dadurch, dass die Induktionsantenne 10A - anstelle des elektrisch leitfähigen Festkörpers 20 der Induktionsantenne 10 - einen elektrisch leitfähigen Festkörper 20A umfasst. Die Induktionsantenne 10A umfasst ansonsten (abgesehen von dem Festkörper 20) dieselben Bauteile wie die Induktionsantenne 10 gemäss Fig. 1-14.

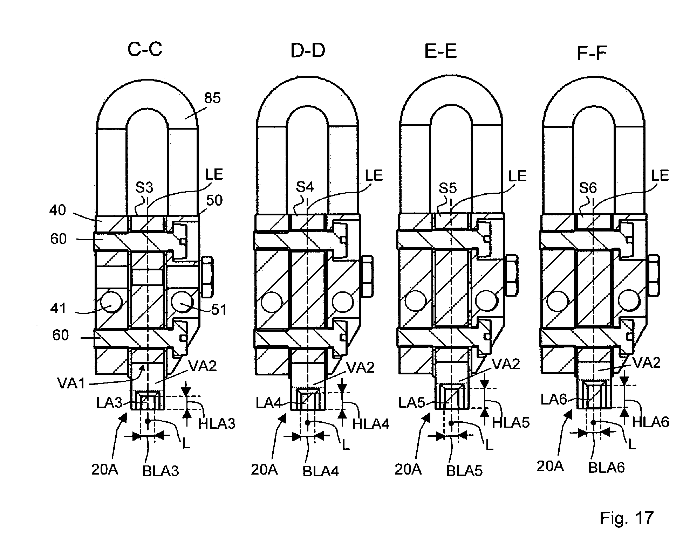

In dem Festkörper 20A ist - wie im Falle des Festkörpers 20 - ein sich entlang der (in Fig. 15 nicht dargestellten und in den Fig. 16 und 17 in einem Querschnitt dargestellten) Lötlinie L erstreckender Strompfad für einen elektrischen Wechselstrom ausgebildet, wobei der elektrische Wechselstrom entlang des Strompfads derart geführt ist, dass er in der Lötlinie L oder in einer Umgebung der Lötlinie L ein magnetisches Wechselfeld erzeugt. Zur Einkopplung des Wechselstroms in den Strompfad und zur Auskopplung des Wechselstroms aus dem Strompfad können das Stromeinkopplungselement 80 und das Stromauskopplungselement 82 an einen (in Fig. 15-17 nicht dargestellten) Wechselstromgenerator angeschlossen werden (analog zum Wechselstromgenerator 11 im Falle der Induktionsantenne 10 gemäss Fig. 2).

Der elektrisch leitfähige Festkörper 20A der Induktionsantenne 10A hat dabei im Wesentlichen dieselbe Konstruktion wie der elektrisch leitfähige Festkörper 20 der Induktionsantenne 10A: Der Festkörper 20A ist dementsprechend ebenfalls in Segmente SE und S1-S12 gegliedert (wie der Festkörper 20 gemäss der Darstellung in Fig. 5-8), wobei Abschnitte dieser Segmente (im Falle des Festkörpers 20 gemäss der Darstellung in Fig. 5-8) einen sich im Wesentlichen parallel zur Lötlinie L erstreckenden Teil FSP bilden, welcher durch einen Luftspalt von der Lötlinie L getrennt ist. Dabei entsprechen die Segmente S1-S12 des Festkörpers 20A hinsichtlich ihrer Form im Wesentlichen den Segmenten S1-S12 des Festkörpers 20, d.h. jedes der Segmente S1-S12 des Festkörpers 20A weist - entsprechend der in Fig. 7B dargestellten Form eines der Segmente S1-S12 des Festkörpers 20 - einen sich im Wesentlichen parallel zur Lötlinie L erstreckenden länglichen Abschnitt (entsprechend dem Abschnitt LA gemäss Fig. 7B) auf und umfasst zusätzlich einen dem Abschnitt VA gemäss Fig. 7B entsprechenden, sich vertikal zur Lötlinie L erstreckenden Abschnitt, welcher (den Abschnitten VA1 und VA2 des Abschnitts VA gemäss Fig. 7B entsprechende) Abschnitte VA1 und VA2 aufweist.

Der elektrisch leitfähige Festkörper 20A der Induktionsantenne 10A unterscheidet sich allerdings von dem Festkörper 20 der Induktionsantenne 10 dadurch, dass die jeweiligen länglichen Abschnitte der Segmente S1-S12 des Festkörpers 20A hinsichtlich ihrer Form nicht identisch sind. Um zwischen den jeweiligen länglichen Abschnitten der Segmente S1-S12 unterscheiden zu können, sind die länglichen Abschnitte der Segmente S1-S12 in den Fig. 15-17 mit den Bezugszeichen LA1, LA2, LA3, LA4, LA5, LA6, LA7, LA8, LA9, LA10, LA11 und LA12 bezeichnet.

Analog zur Anordnung des Stromeinkopplungselement 80 und des Stromauskopplungselements 82 der Induktionsantenne 10 sind das Stromeinkopplungselement 80 und das Stromauskopplungselement 82 der Induktionsantenne 10 derart (über die Kurzschlusselemente 61 und 62) mit den jeweiligen vertikalen Abschnitten VA verschiedener Segmente des Festkörpers 20A verbunden, dass der elektrische Wechselstrom durch die jeweiligen länglichen Abschnitte des sich im Wesentlichen parallel zur Lötlinie L erstreckenden Teils FSP des Festkörpers 20A fliessen muss und in der Umgebung der jeweils vom Wechselstrom durchflossenen länglichen Abschnitte des Festkörpers 20A ein magnetisches Wechselfeld erzeugt (mit einem räumlichen Verlauf der Feldlinien analog zur Darstellung des magnetischen Wechselfeldes H in Fig. 14). Dementsprechend ist das von der Induktionsantenne 10A erzeugte magnetische Wechselfeld in der Lötlinie L in der Umgebung der jeweiligen länglichen Abschnitte LA1-LA12 des Festkörpers 20A jeweils senkrecht zur Lötebene LE gerichtet (in Fig. 15-17 nicht dargestellt).

Wie Fig. 15 und 17 andeuten, haben alle länglichen Abschnitte LA1, LA2, LA3, ...., LA12 des Festkörpers 20A jeweils einen Querschnitt mit einer rechteckigen Querschnittsfläche, wobei der Flächeninhalt der jeweiligen Querschnittsfläche im Wesentlichen über die gesamte Länge des jeweiligen länglichen Abschnitts konstant ist. Allerdings können - wie insbesondere Fig. 17 andeutet - verschiedene längliche Abschnitte LA1, LA2, LA3, ...., LA12 unterschiedlich grosse Querschnittsflächen haben, sodass die Stromdichte des elektrischen Wechselstroms in verschiedenen länglichen Abschnitten des sich im Wesentlichen parallel zur Lötlinie L erstreckenden Teils FSP unterschiedlich sein kann. Dementsprechend kann die Feldstärke des magnetischen Wechselfelds, welches der elektrische Wechselstrom jeweils in einer Umgebung der verschiedenen länglichen Abschnitte LA1, LA2, LA3, ...., LA12 jeweils an der Lötlinie L erzeugt, in den Umgebungen verschiedener länglicher Abschnitte unterschiedlich gross sein und somit entlang der Lötlinie L als Funktion des Ortes variieren (jeweils abhängig vom Flächeninhalt und/oder der Form der Querschnittsfläche des jeweiligen länglichen Abschnitts LA1, LA2, LA3, ...., LA12). Durch eine geeignete Wahl des Flächeninhalts und/oder der Form der Querschnittsflächen der Abschnitte LA1, LA2, LA3, ...., LA12 kann somit eine räumliche Variation der Feldstärke des magnetischen Wechselfeldes entlang der Lötlinie L - abhängig von den jeweiligen Erfordernissen - realisiert werden.

In der Ausführungsform gemäss Fig. 15-17 sind die Querschnittsflächen der LA1, LA2, LA3, ...., LA12 beispielsweise derart gewählt, dass die länglichen Abschnitte, welche einem der beiden Enden 20A' bzw. 20A" des Festkörpers 20A am nächsten sind (d.h. die länglichen Abschnitte LA1 und LA12), jeweils die kleinste Querschnittsfläche (von allen länglichen Abschnitten LA1, LA2, LA3, ...., LA12) aufweisen, und die länglichen Abschnitte, welche in etwa in der Mitte zwischen den beiden Enden 20A' bzw. 20A" des Festkörpers 20A angeordnet sind (d.h. die länglichen Abschnitte LA6 und LA7), jeweils die grösste Querschnittsfläche (von allen länglichen Abschnitten LA1, LA2, LA3, ...., LA12) aufweisen. Dabei ist die Querschnittsfläche eines der länglichen Abschnitte LA2, LA3, LA4, LA5 und LA6 umso grösser, je weiter der jeweilige längliche Abschnitt von dem Ende 20A" des Festkörpers 20A entfernt ist. Entsprechend ist die Querschnittsfläche eines der länglichen Abschnitte LA7, LA8, LA9, LA10 und LA11 umso grösser, je weiter der jeweilige längliche Abschnitt von dem Ende 20A' des Festkörpers 20A entfernt ist.

Zur Illustration dieses Sachverhalts sei auf Fig. 17 verwiesen: In Fig. 17 sind beispielsweise die länglichen Abschnitte LA3, LA4, LA5 bzw. LA6 jeweils in einem Querschnitt (entlang einer der Schnittachsen C-C, D-D, E-E bzw. F-F gemäss Fig. 15) dargestellt und für jeden der länglichen Abschnitte LA3, LA4, LA5 bzw. LA6 die Erstreckung BLA3, BLA4, BLA5 bzw. BLA6 des jeweiligen länglichen Abschnitts senkrecht zur Lötebene LE und die Erstreckung HLA3, HLA4, HLA5 bzw. HLA6 des jeweiligen länglichen Abschnitts parallel zur Lötebene LE dargestellt. Wie aus Fig. 17 ersichtlich, sind gemäss dem vorliegenden Beispiel die Erstreckungen der länglichen Abschnitte LA3, LA4, LA5 bzw. LA6 senkrecht zur Lötebene LE jeweils identisch (BLA3 = BLA4 = BLA5 = BLA6), während die Erstreckungen der länglichen Abschnitte LA3, LA4, LA5 bzw. LA6 parallel zur Lötebene LE derart gewählt sind, dass HLA3 < HLA4 < HLA5 < HLA6. Da die Querschnittsflächen der länglichen Abschnitte LA3, LA4, LA5 bzw. LA6 jeweils die Form eines Rechtecks aufweisen, ist folglich der Flächeninhalt (BLA6 * HLA6) der Querschnittsfläche des länglichen Abschnitts LA6 grösser als der Flächeninhalt (BLA5 * HLA5) der Querschnittsfläche des länglichen Abschnitts LA5 und grösser als der Flächeninhalt (BLA4 * HLA4) der Querschnittsfläche des länglichen Abschnitts LA4 und grösser als der Flächeninhalt (BLA3 * HLA3) der Querschnittsfläche des länglichen Abschnitts LA3. Wie Fig. 15 weiterhin andeutet, sind im vorliegenden Beispiel die jeweiligen Querschnittsflächen der länglichen Abschnitte LA6 und LA7 identisch; entsprechend sind die jeweiligen Querschnittsflächen der länglichen Abschnitte LA5 und LA8 identisch; weiterhin sind die jeweiligen Querschnittsflächen der länglichen Abschnitte LA4 und LA9 identisch; ausserdem sind die jeweiligen Querschnittsflächen der länglichen Abschnitte LA3 und LA10 identisch. Dementsprechend zeigt die Feldstärke des magnetischen Wechselfelds in der Lötlinie L jeweils entlang der länglichen Abschnitte LA3, LA4, LA5, LA6, LA7, LA8, LA9 und LA10 eine räumliche Variation, welche durch die jeweiligen Erstreckungen dieser länglichen Abschnitte parallel zur Lötebene LE bzw. durch die Variation dieser Erstreckungen entlang der Lötlinie L bestimmt ist.

Fig. 16 und 17 zeigen exemplarisch eine weitere Möglichkeit, eine räumliche Variation des magnetischen Wechselfelds entlang der Lötlinie L mittels verschiedener Körper, welche aus einem magnetischen Material mit einer Permeabilitätszahl (relative Permeabilität) µᵣ>1 (z.B. aus Ferrit) bestehen und entlang der Lötlinie L platziert sind, zu realisieren: Im Falle der Induktionsantenne 10A sind mehrere derartige Körper (mit µᵣ>1), im vorliegenden Beispiel die Körper 90-1, 90-2, 90-11 und 90-12 an dem sich im Wesentlichen parallel zur Lötlinie L erstreckenden Teils FSP des Festkörpers 20A platziert, sodass die jeweiligen Körper von dem von der Induktionsantenne 10A erzeugten magnetischen Wechselfeld durchdrungen werden. Die Körper 90-1, 90-2, 90-11 und 90-12 ermöglichen aufgrund ihrer relativ grossen magnetischen Permeabilität eine lokale Konzentration bzw. Verstärkung des magnetischen Wechselfeldes in ihrer jeweiligen Umgebung und ermöglichen deshalb eine Beeinflussung des magnetischen Wechselfeldes, insbesondere eine Beeinflussung der Feldstärke des magnetischen Wechselfeldes in der Lötlinie L bzw. in einer Umgebung der Lötlinie L (jeweils abhängig von der magnetischen Permeabilität und/oder des Volumens und/oder der Form des jeweiligen -Körpers 90-1, 90-2, 90-11 und 90-12 und/oder der Anordnung des jeweiligen Körpers relativ zu dem sich im Wesentlichen parallel zur Lötlinie L erstreckenden Teils FSP des Festkörpers 20A).

Wie Fig. 15 und 16 andeuten, erstrecken sich die Körper 90-1, 90-2, 90-11 und 90-12 entlang der Lötlinie L über eine Länge, welche in etwa der Länge eines der länglichen Abschnitte LA1, LA2, LA11 bzw. LA12 in Richtung der Lötlinie L entspricht. Dabei sind die verschiedenen Körper 90-1, 90-2, 90-11 und 90-12 jeweils an verschiedenen länglichen Abschnitten angeordnet: Der Körper 90-1 ist am länglichen Abschnitt LA1, der Körper 90-2 am länglichen Abschnitt LA2, der Körper 90-11 am länglichen Abschnitt LA11 und der Körper 90-12 am länglichen Abschnitt LA12 angeordnet.

Wie Fig. 15 und 16 weiterhin andeuten, sind nicht alle Körper 90-1, 90-2, 90-11 und 90-12 hinsichtlich ihrer Form identisch. Der Körper 90-1 hat im vorliegenden Beispiel die Form eines Quaders; dieser weist - in einer Ebene senkrecht zur Lötlinie L - einen quadratischen Querschnitt auf und ist auf einer von der Lötlinie L abgewandten Seite des länglichen Abschnitts LA1 in einem Zwischenraum, welcher zwischen dem länglichen Abschnitt LA1 und dem Abschnitt VA1 des Segments S1 des Festkörpers 20A ausgebildet ist, angeordnet und füllt diesen Zwischenraum im wesentlichen vollständig aus. Der Körper 90-12 ist hinsichtlich Form und Grösse identisch mit dem Körper 90-1, ist allerdings auf einer von der Lötlinie L abgewandten Seite des länglichen Abschnitts LA12 in einem Zwischenraum, welcher zwischen dem länglichen Abschnitt LA12 und dem Abschnitt VA1 des Segments S12 des Festkörpers 20A ausgebildet ist, angeordnet.

Der Körper 90-2 ist hingegen als ein sich parallel zur Lötlinie L erstreckender, quaderförmiger Körper ausgebildet, welcher auf einer der Lötlinie L zugewandten Seite eine sich parallel zur Lötlinie L erstreckende Nut 90A aufweist, wobei die Kontur der Nut 90A - in einem Querschnitt senkrecht zur Lötlinie L - an die Querschnittsfläche des länglichen Abschnitts LA2 angepasst ist, sodass der längliche Abschnitt LA2 in die Nut 90A passt. Wie insbesondere Fig. 16 andeutet, ist der Körper 90-2 in einen Zwischenraum, welcher zwischen dem länglichen Abschnitt LA2 und dem Abschnitt VA1 des Segments S2 des Festkörpers 20A ausgebildet ist, derart eingesetzt und auf den länglichen Abschnitt LA2 derart aufgesetzt, dass der längliche Abschnitt LA2 in der Nut 90A des Körpers 90-2 angeordnet ist und der Körper 90-2 den länglichen Abschnitt LA2 auf drei seiner vier Seitenflächen umschliesst (Fig. 16). Um zu erreichen, dass der Körpers 90-2 auf dem länglichen Abschnitt LA2 einen stabilen Sitz hat, ist zusätzlich ein Körper 91 vorgesehen, welcher zwischen den Körpers 90-2 und den Abschnitt VA1 des Segments S2 des Festkörpers 20A einsetzbar ist, sodass der Körper 90-2 zwischen dem länglichen Abschnitt LA2 und dem Abschnitt VA1 des Segments S2 blockiert ist (Fig. 16).

Wie Fig. 15 weiterhin andeutet, hat der Körper 90-11 dieselbe Form wie der Körper 90-2 und weist auch in einem Querschnitt senkrecht zur Lötlinie L dasselbe Profil auf wie der Körper 90-2 (wie in Fig. 16 gemäss der Schnittdarstellung entlang der Schnittachsen B-B dargestellt). Dementsprechend ist der Körper 90-11 auf den länglichen Abschnitt LA11 des Segments S11 des Festkörpers 20A auf dieselbe Weise gesetzt wie der Körper 20-2 auf den länglichen Abschnitt LA2 gesetzt ist.

Wie Fig. 15 und 16 weiterhin andeuten, weisen die länglichen Abschnitte LA1, LA2, LA11 und LA12 jeweils (senkrecht zur Lötlinie L) Querschnittsflächen auf, welche hinsichtlich Form und Flächeninhalt identisch sind. Wäre die Induktionsantenne 10A - abweichend von dem in Fig. 15-17 dargestellten Beispiel - nicht mit den Körpern 90-1, 90-2, 90-11 und 90-12 versehen, dann würde die Induktionsantenne 10A in der Lötlinie L folglich jeweils ein magnetisches Wechselfeld erzeugen, welches an den länglichen Abschnitten LA1, LA2, LA11 und LA12 jeweils im Wesentlichen dieselbe Feldstärke aufweisen würde. Da die Körper 90-1 und 90-2 sich hinsichtlich ihrer Form und ihrer Anordnung unterscheiden, führen die Körper 90-1 und 90-2 in einer Umgebung des länglichen Abschnitts LA1 und einer Umgebung des länglichen Abschnitts LA2 jeweils zu einer unterschiedlichen Konzentration bzw. Verstärkung des magnetischen Wechselfeldes und bewirken somit eine räumliche Variation der Feldstärke des magnetischen Wechselfeldes entlang der Lötlinie L in der Nähe der länglichen Abschnitte LA1 und LA2. Entsprechend können die Körper 90-11 und 90-12 in einer Umgebung des länglichen Abschnitts LA11 und einer Umgebung des länglichen Abschnitts LA12 jeweils zu einer unterschiedlichen Konzentration bzw. Verstärkung des magnetischen Wechselfeldes führen und somit eine räumliche Variation der Feldstärke des magnetischen Wechselfeldes entlang der Lötlinie L in der Nähe der länglichen Abschnitte LA11 und LA12 bewirken.

Eine weitere Möglichkeit, eine räumliche Variation des magnetischen Wechselfeldes entlang der Lötlinie L zu realisieren, besteht offenbar darin, die verschiedenen Körper, im vorliegenden Beispiel Körper 90-1, 90-2, 90-11 und 90-12, jeweils aus verschiedenen Werkstoffen zu fertigen, welche sich hinsichtlich ihrer magnetischen Permeabilität unterscheiden und auf diese Weise eine unterschiedliche Konzentration bzw. Verstärkung des magnetischen Wechselfeldes in ihrer jeweiligen Umgebung bewirken. Zusätzlich können auch an verschiedenen länglichen Abschnitten, welche unterschiedliche Querschnittsflächen aufweisen, jeweils Körper aus einem magnetischen Material mit einer Permeabilitätszahl (relative Permeabilität) µᵣ>1 (z.B. aus Ferrit) angeordnet werden. Diese Körper können sich auch hinsichtlich ihrer Form und/oder ihres Volumens und/oder ihrer magnetischen Permeabilität und/oder hinsichtlich ihrer Anordnung relativ zur Lötlinie L (beispielsweise hinsichtlich ihres Abstands relativ zur Lötlinie L) bzw. hinsichtlich ihrer Anordnung relativ zu den jeweiligen länglichen Abschnitten des Festkörpers 20A unterscheiden.

## Patentansprüche

1. Lötvorrichtung (8) zum Befestigen eines elektrisch leitfähigen Bandes (5) an einer geraden Stromsammelschiene (3) einer Solarzelle (1) entlang einer geraden Lötlinie (L) mittels induktivem Löten, welche umfasst:
mehrere Niederhalterelemente (P) zum Niederhalten des Bandes (5) auf einer Oberfläche der Stromsammelschiene (3) und
eine Induktionsantenne (10; 10A) mit einem sich entlang der Lötlinie (L) erstreckenden Strompfad (SP) für einen elektrischen Wechselstrom (I), welcher elektrische Wechselstrom (I) entlang des Strompfads (SP) derart geführt ist, dass er in der Lötlinie (L) oder in einer Umgebung der Lötlinie ein magnetisches Wechselfeld (H) erzeugt,
wobei die Niederhalterelemente (P) derart ausgebildet sind, dass sie sich jeweils senkrecht zur Lötlinie (L) und in einer Lötebene (LE), in welcher die Lötlinie (L) liegt, erstrecken, und
wobei die Niederhalterelemente (P) in einer Reihe hintereinander derart angeordnet sind, dass zwischen jeweils zwei der Niederhalterelemente (P), welche in der Reihe unmittelbar hintereinander angeordnet sind, ein Zwischenraum (Z) ausgebildet ist und die jeweiligen Niederhalterelemente (P) in der Lötebene (LE) relativ zu der Lötlinie (L) bewegbar sind,
**dadurch gekennzeichnet, dass**
der Strompfad (SP) in einem elektrisch leitfähigen Festkörper (20; 20A) ausgebildet ist und dieser Festkörper mindestens einen sich im Wesentlichen parallel zur Lötlinie (L) erstreckenden Teil (FSP) umfasst, welcher durch einen Luftspalt (LS) von der Lötlinie (L) getrennt ist und in welchem mindestens ein Abschnitt (SPA) des Strompfads (SP) ausgebildet ist,
wobei der sich im Wesentlichen parallel zur Lötlinie (L) erstreckende Teil (FSP) mehrere Ausnehmungen (21) aufweist, welche in einer Reihe hintereinander entlang der Lötlinie (L) angeordnet sind und sich entlang der Lötebene (LE) jeweils vertikal zur Lötlinie (L) derart erstrecken, dass jeweils eines der Niederhalterelemente (P) bewegbar in einer dieser Ausnehmungen (21) angeordnet ist,
wobei der sich im Wesentlichen parallel zur Lötlinie (L) erstreckende Teil (FSP) mehrere längliche Abschnitte (LA; LA1-LA12) umfasst, von denen jeder eine sich parallel zur Lötlinie (L) erstreckende Längsachse aufweist,
wobei zwischen jeweils zwei der Ausnehmungen (21), welche in der einen Reihe unmittelbar hintereinander angeordnet sind, jeweils einer der länglichen Abschnitte (LA; LA1-LA12) angeordnet ist und sich geradlinig und
parallel zur Lötlinie (L) von einer dieser zwei Ausnehmungen (21) zur anderen dieser zwei Ausnehmungen (21) erstreckt, und
wobei einer oder mehrere der länglichen Abschnitte (LA) Teil des mindestens einen Abschnitts (SPA) des Strompfads (SP) sind.

2. Lötvorrichtung (8) nach Anspruch 1, wobei jeder längliche Abschnitt (LA; LA1-LA12) und/oder der mindestens eine sich im Wesentlichen parallel zur Lötlinie (L) erstreckende Abschnitt (FSP) des elektrisch leitfähigen Festkörpers (20) und/oder der elektrisch leitfähige Festkörper (20; 20A) symmetrisch zur Lötebene (LE) ausgebildet ist.

3. Lötvorrichtung nach einem der Ansprüche 1 oder 2, wobei in zwei der Ausnehmungen (21), welche in der Reihe unmittelbar hintereinander angeordnet sind, zwei Niederhalterelemente (P) in einem Abstand (D) zueinander angeordnet sind und
sich der längliche Abschnitt (LA; LA1-LA12) zwischen diesen zwei Ausnehmungen (21) entlang der Lötlinie (L) mit konstantem Querschnitt (Q) über eine Länge (LLA) erstreckt, welche mindestens 50% des Abstands (D) zwischen den zwei Niederhalterelementen (P) beträgt.

4. Lötvorrichtung nach einem der Ansprüche 1 - 3, wobei die länglichen Abschnitte (LA; LA1-LA12) senkrecht zur Lötebene (LE) eine Dimension aufweisen, welche in etwa so gross ist wie eine Breite der Stromsammelschiene (3) und/oder eine Breite des elektrisch leitfähigen Bandes (5) senkrecht zur Lötebene (LE) und/oder kleiner oder gleich einem Durchmesser (DP) eines der Niederhalterelemente (P) senkrecht zur Lötebene (LE) ist.

5. Lötvorrichtung nach einem der Ansprüche 1 - 4, wobei die länglichen Abschnitte (LA) des sich im Wesentlichen parallel zur Lötlinie (L) erstreckenden Teils (FSP) des elektrisch leitfähigen Festkörpers (20) in einer Reihe hintereinander entlang der Lötlinie (L) angeordnet sind und sich die Längachsen der länglichen Abschnitte (LA) entlang einer parallel zur Lötlinie (L) angeordneten Geraden (G) erstrecken.

6. Lötvorrichtung nach einem der Ansprüche 4 oder 5, wobei der sich im Wesentlichen parallel zur Lötlinie (L) erstreckenden Teil (FSP) des elektrisch leitfähigen Festkörpers (20; 20A) mehrere jeweils eine der Ausnehmungen (21) umfassende Abschnitte (AA) aufweist und diese Abschnitte in einer Reihe hintereinander entlang der Lötlinie (L) angeordnet sind,
wobei jeweils zwei der jeweils eine der Ausnehmungen (21) umfassende Abschnitte (AA), welche in der Reihe unmittelbar hintereinander angeordnet sind, über einender länglichen Abschnitte (LA; LA1-LA12) miteinander verbunden sind.

7. Lötvorrichtung nach einem der Ansprüche 1-6, wobei der elektrisch leitfähige Festkörper (20, 20A) mehrere sich vertikal zur Lötlinie (L) erstreckende Abschnitte (VA) umfasst, welche jeweils auf einer von der Lötlinie (L) abgewandten Seite des mindestens einen sich im Wesentlichen parallel zur Lötlinie (L) erstreckenden Teils (FSP) des elektrisch leitfähigen Festkörper (20) in einer Reihe hintereinander entlang der Lötlinie (L) angeordnet sind,
wobei jeder dieser sich vertikal zur Lötlinie (L) erstreckenden Abschnitte (VA) an einer der Lötlinie (L) zugewandten Seite zumindest mit einem Ende (LA') eines der länglichen Abschnitte (LA) des mindestens einen sich im Wesentlichen parallel zur Lötlinie (L) erstreckenden Teils (FSP) des elektrisch leitfähigen Festkörpers (20) verbunden ist und
wobei zwei der sich vertikal zur Lötlinie (L) erstreckende Abschnitte (VA), welche in der Reihe unmittelbar hintereinander angeordnet sind, durch einen sich vertikal zur Lötlinie (L) erstreckenden Spalt (T) getrennt sind und an ihren der Lötlinie (L) zugewandten Seiten über einen der länglichen Abschnitte (LA) des mindestens einen sich im Wesentlichen parallel zur Lötlinie (L) erstreckenden Teils (FSP) des elektrisch leitfähigen Festkörpers (20, 20A) verbunden sind.

8. Lötvorrichtung nach Anspruch 7, wobei sich durch mindestens einen der sich vertikal zur Lötlinie (L) erstreckende Abschnitte (VA) eine der Ausnehmungen (21) erstreckt.

9. Lötvorrichtung nach einem der Ansprüche 7 - 8, wobei jeder der sich vertikal zur Lötlinie (L) erstreckenden Abschnitte (VA) symmetrisch zur Lötebene (LE) ausgebildet ist.

10. Lötvorrichtung nach einem der Ansprüche 7 - 9, mit Mitteln (22, 23, 60) zum Befestigen der sich vertikal zur Lötlinie (L) erstreckenden Abschnitte (VA), um den elektrisch leitfähigen Festkörper (20, 20A) in einer vorgegebenen Position relativ zur Solarzelle (1) zu halten.

11. Lötvorrichtung nach einem der Ansprüche 7-10, mit einer Kühleinrichtung zum Kühlen mindestens eines der sich vertikal zur Lötlinie (L) erstreckenden Abschnitte (VA), wobei die länglichen Abschnitte (LA) des sich im Wesentlichen parallel zur Lötlinie (L) erstreckenden Teils (FSP) des elektrisch leitfähigen Festkörpers (20; 20A) indirekt kühlbar sind mittels Wärmeleitung über den mindestens einen der sich vertikal zur Lötlinie (L) erstreckenden Abschnitte (VA), welcher mittels der Kühleinrichtung gekühlt werden kann,
wobei die Kühleinrichtung mindestens einen Kühlkörper (40, 50) umfasst, welcher mit mindestens einem der sich vertikal zur Lötlinie (L) erstreckenden Abschnitte (VA) des elektrisch leitfähigen Festkörpers (20; 20A) in einem thermischen Kontakt steht, und
der Kühlkörper (40, 50) mittels eines Kühl-Fluids (KF) kühlbar ist.

12. Lötvorrichtung nach Anspruch 11, wobei der mindestens eine Kühlkörper (40, 50) mit dem mindestens einen der sich vertikal zur Lötlinie (L) erstreckenden Abschnitte (VA) des elektrisch leitfähigen Festkörpers (20; 20A) verbunden ist über mindestens einen Isolationskörper (70) aus einem elektrisch isolierenden, wärmeleitenden Material oder
eine Beschichtung aus einem elektrisch isolierenden, wärmeleitenden Material, welche auf dem mindestens einen der sich vertikal zur Lötlinie (L) erstreckenden Abschnitte (VA) des elektrisch leitfähigen Festkörpers (20; 20A) aufgebracht ist, und/oder eine Beschichtung aus einem elektrisch isolierenden, wärmeleitenden Material, welche auf dem mindestens einen Kühlkörper (40, 50) aufgebracht ist.

13. Lötvorrichtung nach Anspruch 12, wobei die Anzahl der Kühlkörper (40, 50) zwei beträgt und diese zwei Kühlkörper aus einem elektrisch leitfähigen Material bestehen,
mit einem Stromeinkopplungselement (80) zum Einkoppeln des elektrischen Wechselstroms (I) in den Strompfad (SP), wobei der eine der zwei Kühlkörper (40) mit dem Stromeinkopplungselement (80) verbunden ist,
mit einer ersten elektrischen Verbindung (61) zwischen dem einen der zwei Kühlkörper (40) und einem der sich vertikal zur Lötlinie (L) erstreckenden Abschnitte (VA) des elektrisch leitfähigen Festkörpers (20; 20A),
mit einem Stromauskopplungselement (82) zum Auskoppeln des elektrischen Wechselstroms (I) aus dem Strompfad (SP), wobei der andere der zwei Kühlkörper (50) mit dem Stromauskopplungselement (82) verbunden ist, und
mit einer zweiten elektrischen Verbindung (62) zwischen dem anderen der zwei Kühlkörper (50) und einem anderen der sich vertikal zur Lötlinie (L) erstreckenden Abschnitte (VA) des elektrisch leitfähigen Festkörpers (20; 20A).

14. Lötvorrichtung nach Anspruch 13, wobei
das Stromeinkopplungselement (80) als eine aus einem elektrisch leitfähigen Material bestehende KühlfluidLeitung (81) ausgebildet ist, durch welche Kühlfluid (KF) dem einen der zwei Kühlkörper (40) zuführbar und/oder von dem einen der zwei Kühlkörper (40) abführbar ist und/oder
das Stromauskopplungselement (82) als eine aus einem elektrisch leitfähigen Material bestehende KühlfluidLeitung (83) ausgebildet ist, durch welche Kühlfluid (KF) dem anderen der zwei Kühlkörper (50) zuführbar und/oder von dem anderen der zwei Kühlkörper (50) abführbar ist.

15. Lötvorrichtung nach einem der Ansprüche 13 oder 14, wobei
die erste elektrische Verbindung ein erstes Kurzschlusselement (61) umfasst, mit welchem ein elektrischer Kurzschluss zwischen dem ersten Kühlkörper (40) und einem der sich vertikal zur Lötlinie (L) erstreckenden Abschnitte (VA) des elektrisch leitfähigen Festkörpers (20; 20A) herstellbar ist, wobei dieses Kurzschlusselement (61) an verschiedenen Positionen (44-1, 44-2, 44-3, 45-1, 45-2, 45-3) relativ zum ersten Kühlkörper (40) montierbar ist, um einen elektrischen Kurzschluss zwischen jeweils verschiedenen der sich vertikal zur Lötlinie (L) erstreckenden Abschnitte (VA) des elektrisch leitfähigen Festkörpers (20; 20A) und dem ersten Kühlkörper (40) herzustellen, und/oder
die zweite elektrische Verbindung ein zweites Kurzschlusselement (62) umfasst, mit welchem ein elektrischer Kurzschluss zwischen dem zweiten Kühlkörper (50) und einem der sich vertikal zur Lötlinie (L) erstreckenden Abschnitte (VA) des elektrisch leitfähigen Festkörpers (20; 20A) herstellbar ist, wobei dieses zweite Kurzschlusselement (62) an verschiedenen Positionen (54-1, 54-2, 54-3, 55-1, 55-2, 55-3) relativ zum zweiten Kühlkörper (50) montierbar ist, um einen elektrischen Kurzschluss zwischen jeweils verschiedenen der sich vertikal zur Lötlinie (L) erstreckenden Abschnitte (VA) des elektrisch leitfähigen Festkörpers (20; 20A) und dem zweiten Kühlkörper (50) herzustellen.

16. Lötvorrichtung nach einem der Ansprüche 1-15, wobei einer der länglichen Abschnitte (LA3) des elektrisch leitfähigen Festkörpers (20A) eine Querschnittsfläche aufweist, deren Flächeninhalt (BLA3*HLA3) grösser oder kleiner als der Flächeninhalt (BLA4*HLA4; BLA5*HLA5; BLA6*HLA6) einer Querschnittsfläche mindestens eines anderen der länglichen Abschnitte (LA4, LA5, LA6) des elektrisch leitfähigen Festkörpers (20A) ist.

17. Lötvorrichtung nach einem der Ansprüche 1-16, wobei die Induktionsantenne (10A) mehrere Körper (90-1, 90-2, 90-11, 90-12) aus Ferrit oder einem anderen magnetischen Material mit einer relativen Permeabilität µᵣ>1 umfasst, wobei jeder dieser Körper (90-1, 90-2, 90-11, 90-12) an einem der länglichen Abschnitte (LA1, LA2, LA11, LA12) des elektrisch leitfähigen Festkörpers (20A) angeordnet ist und sich mindestens zwei dieser Körper (90-1, 90-2) hinsichtlich ihrer Form und/oder ihres Volumens und/oder ihrer magnetischen Permeabilität voneinander unterscheiden.
